(19) **Europäisches Patentamt / European Patent Office / Office européen des brevets**

(11) **EP 4 668 506 A1**

(12) # EUROPEAN PATENT APPLICATION
published in accordance with Art. 153(4) EPC

(43) Date of publication:
**24.12.2025 Bulletin 2025/52**

(21) Application number: **24756920.5**

(22) Date of filing: **14.02.2024**

(51) International Patent Classification (IPC):
**H01S 5/11** (2021.01)   **H01S 5/18** (2021.01)

(52) Cooperative Patent Classification (CPC):
**H01S 5/11; H01S 5/18**

(86) International application number:
**PCT/JP2024/005062**

(87) International publication number:
**WO 2024/172079 (22.08.2024 Gazette 2024/34)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **16.02.2023 JP 2023022957**

(71) Applicant: **Kyoto University
Kyoto-shi, Kyoto 606-8501 (JP)**

(72) Inventors:
• **NODA, Susumu
Kyoto-shi, Kyoto 606-8501 (JP)**
• **IMAMURA, Akira
Kyoto-shi, Kyoto 606-8501 (JP)**
• **SAKATA, Ryoichi
Kyoto-shi, Kyoto 606-8501 (JP)**
• **ISHIZAKI, Kenji
Kyoto-shi, Kyoto 606-8501 (JP)**
• **INOUE, Takuya
Kyoto-shi, Kyoto 606-8501 (JP)**
• **DE ZOYSA, Menaka
Kyoto-shi, Kyoto 606-8501 (JP)**

(74) Representative: **Hoeger, Stellrecht & Partner
Patentanwälte mbB
Uhlandstrasse 14c
70182 Stuttgart (DE)**

(54) **TWO-DIMENSIONAL PHOTONIC CRYSTAL LASER**

(57)     A two-dimensional photonic crystal layer (10) includes: a pair of electrodes (171, 172); an active layer (11) that is provided between the pair of electrodes and generates light of a predetermined wavelength when an electric current is supplied from the electrodes; and a two-dimensional photonic crystal layer (12) that is provided between any one of the pair of electrodes and the active layer and has a plate-shaped base member (121) and a plurality of modified refractive index regions (122) disposed in the base member and having different refractive indexes from the base member, wherein each of the plurality of modified refractive index regions is disposed to be shifted from lattice points of a two-dimensional lattice periodically disposed in the base member at an in-plane period corresponding to the predetermined wavelength by a different positional shift amount, and/or has an amount of area different from a predetermined reference area by an area shift amount different from each other at each lattice point of the two-dimensional lattice or at a position shifted from the lattice point by the positional shift amount, and the positional shift amount and/or the area shift amount of each of the plurality of modified refractive index regions are/is a modulation value determined by a composite period in which a plurality of different in-plane periods are superimposed at a modified refractive index region in which the modulation value is a value between a predetermined upper limit value and a predetermined lower limit value at a lattice point where the modified refractive index region is disposed, are/is the upper limit value at a modified refractive index region in which the modulation value exceeds the upper limit value, and are/is the lower limit value at a modified refractive index region in which the modulation value is less than the lower limit value.

EP 4 668 506 A1

# Fig. 1

(a)

(b)

$\Delta d(r\uparrow)=0$
$\Delta S(r\uparrow)=0$
$(S=S_0)$

**Description**

TECHNICAL FIELD

The present invention relates to a two-dimensional photonic crystal laser (also referred to as "two-dimensional photonic crystal surface emitting laser") in which a two-dimensional photonic crystal is used for amplifying light.

BACKGROUND ART

A two-dimensional photonic crystal laser includes an active layer, a two-dimensional photonic crystal layer, and a pair of electrodes provided so as to sandwich the active layer and the two-dimensional photonic crystal layer. The active layer generates light with a specific wavelength band when being supplied with carriers (positive holes, electrons) from the electrode pair. The two-dimensional photonic crystal layer has a configuration including a plate-shaped base member in which modified refractive index regions whose refractive index differs from that of the base member are periodically disposed two-dimensionally. The modified refractive index regions may be air holes (air) formed in the base member, or made of material different from the material of the base member. In such a two-dimensional photonic crystal laser, only light having a predetermined wavelength corresponding to the period length of the disposition of the modified refractive index regions among light generated in the active layer is amplified in the two-dimensional photonic crystal layer and laser oscillates, and a laser beam is emitted from a surface of the two-dimensional photonic crystal layer.

In a typical two-dimensional photonic crystal laser, modified refractive index regions having the same planar shape are disposed at lattice points of a two-dimensional lattice such as a square lattice, a rectangular lattice, or a triangular lattice, and the laser beam is emitted in a direction perpendicular to the two-dimensional photonic crystal layer.

On the other hand, Patent Literatures 1 and 2 describe a two-dimensional photonic crystal laser including a two-dimensional photonic crystal layer in which a modified refractive index region is disposed so as to be shifted from each lattice point of the two-dimensional lattice by a different shift amount, and/or each of the modified refractive index regions is disposed with a different amount of area. Here, the shift amount is a vector amount (that is, an amount having a magnitude and a direction) in a plane parallel to the two-dimensional photonic crystal layer. The "different shift amount" includes a case where the magnitude of shift is the same and only the direction of shift is different. The shift amount and/or the amount of area change(s) with a predetermined period (longer than the period of disposition of the lattice points) along a predetermined direction parallel to the two-dimensional photonic crystal layer. The period of the change in the shift amount and/or the amount of area is referred to as "modulation period". The shift amount and/or the amount of area in each of the modified refractive index regions modulated with this modulation period are/is referred to as "modulation phase". Such a two-dimensional photonic crystal laser emits two laser beams having an angle (inclination angle) inclined from a direction perpendicular to the two-dimensional photonic crystal layer by an angle according to the modulation period, and having azimuth angles different from each other by 180° in the predetermined direction.

Patent Literature 3 describes a two-dimensional photonic crystal laser including a two-dimensional photonic crystal layer in which a modified refractive index region is disposed at each lattice point or a position shifted from each lattice point of the two-dimensional lattice by an amount of area and/or by a shift amount modulated with a composite period in which different N types (N is an integer of 2 or more) of modulation periods are superimposed. Such a two-dimensional photonic crystal laser emits 2N (four or more) laser beams each having an inclination angle and an azimuth angle according to each modulation period superimposed in the composite period from the two-dimensional photonic crystal layer. In the field of laser imaging detection and ranging (LIDAR), which is a sensor used for remote sensing, and the like, a laser light source that emits a large number of laser beams is required, and the two-dimensional photonic crystal laser described in Patent Literature 3 can be suitably used in such applications.

CITATION LIST

PATENT LITERATURE

Patent Literature 1: WO 2014/136607 A
Patent Literature 2: US 2016/0248224 A
Patent Literature 3: WO 2022/181723 A

SUMMARY OF INVENTION

TECHNICAL PROBLEM

The inventors of the present invention conducted studies on the two-dimensional photonic crystal laser described in Patent Literature 3, and found that, in addition to 2N laser beams corresponding to the composite period (these laser beams are referred to as "proper laser beams"), a large number of unnecessary laser beams having lower intensity than the proper laser beams are emitted. When the proper laser beams have an intensity as described in an embodiment of Patent Literature 3, the intensity of these unnecessary laser beams is negligibly small, but if the intensity of the proper laser beams is increased by increasing the electric current supplied to an active layer, the intensity of the unnecessary laser beams also increases and cannot be ignored.

An object of the present invention is to provide a two-dimensional photonic crystal laser that emits a large number (four or more) of laser beams while suppressing emission of unnecessary laser beams.

SOLUTION TO PROBLEM

A two-dimensional photonic crystal laser according to the present invention aimed at achieving the aforementioned object includes:

a) a pair of electrodes;
b) an active layer that is provided between the pair of electrodes and generates light having a predetermined wavelength when an electric current is supplied from the electrodes; and
c) a two-dimensional photonic crystal layer provided between any one of the pair of electrodes and the active layer and having a plate-shaped base member and a plurality of modified refractive index regions disposed in the base member and having a refractive index different from that of the base member, wherein

each of the plurality of modified refractive index regions is disposed to be shifted from each lattice point of a two-dimensional lattice periodically disposed in the base member in an in-plane period corresponding to the predetermined wavelength by a different positional shift amount, and/or has an amount of area different from a predetermined reference area by an area shift amount different from each other at each lattice point of the two-dimensional lattice or at a position shifted from the lattice point by the positional shift amount, and

the positional shift amount and/or the area shift amount of each of the plurality of modified refractive index regions are/is a modulation value determined by a composite period in which a plurality of different in-plane periods are superimposed at a modified refractive index region in which the modulation value is a value between a predetermined upper limit value and a predetermined lower limit value at a lattice point at which the modified refractive index region is disposed, are/is the upper limit value at a modified refractive index region in which the modulation value exceeds the upper limit value, and are/is the lower limit value at a modified refractive index region in which the modulation value is less than the lower limit value.

The "composite period in which a plurality of different in-plane periods are superimposed" may be a period in which modulations formed with a plurality of different period lengths along one direction (the same direction) parallel to the two-dimensional photonic crystal layer are superimposed on each other, a period in which modulations formed with one period length along each of a plurality of different directions parallel to the two-dimensional photonic crystal layer (the period length may be the same length or different lengths in the respective directions) are superimposed on each other, or a combination of these periods (a period in which modulations formed with a plurality of different period lengths along the plurality of directions are superimposed on each other). The "positional shift amount" includes a distance of shift from the lattice point, a magnitude of an azimuth angle of shift, and a combination of the distance of shift and the magnitude of the azimuth angle.

As a premise for describing the two-dimensional photonic crystal laser according to the present invention, first, the two-dimensional photonic crystal laser described in Patent Literature 3 will be further described. In the two-dimensional photonic crystal laser described in Patent Literature 3, the positional shift amount and/or the area shift amount of the modified refractive index region at each lattice point of the two-dimensional lattice are/is modulated in a composite period in which a plurality of different periods are superimposed, and a modulation phase $\Psi(\vec{r})$ using a vector $\vec{r}$ indicating the position of each lattice point is expressed as follows:

[Expression 1]

$$\Psi\left(r\uparrow\right) = \arg\left\{\int\int\sum_n A_n \exp\left(i\alpha_n\right)\delta\left(k\uparrow - k_n\uparrow\right)\exp\left(ik\uparrow \cdot r\uparrow\right)dk\uparrow\right\}$$

$$= \arg\left\{\sum_n A_n \exp\left(ik_n\uparrow\cdot r\uparrow + i\alpha_n\right)\right\} \quad \cdots(1)$$

Here, $A_n$ and $\exp(i\alpha_n)$ are an amplitude and a phase determined for each n. A vector $k_n\uparrow$ is a wave number vector determined by a combination of an inclination angle and an azimuth angle in each of N (N is an integer of 2 or more; n is any value of 1 to N) laser beams having different inclination angles $\theta_n$ and/or azimuth angles $\varphi_n$. In practice, 2N laser beams having azimuth angles different from each other by 180° at values of n are emitted. For example, in a case where the two-dimensional lattice is a square lattice having a period length a, the vector $k_n\uparrow$ is expressed as follows:
[Expression 2]

$$k_n\uparrow = \left(\left(\frac{1}{2} - \frac{1}{\sqrt{2}n_{\text{eff}}}\sin\theta_n\cos\phi_n\right)\frac{2\pi}{a}, \left(\frac{1}{2} - \frac{1}{\sqrt{2}n_{\text{eff}}}\sin\theta_n\sin\phi_n\right)\frac{2\pi}{a}\right)$$

$$\cdots(2)$$

Using the modulation phase $\Psi(r\uparrow)$, a positional shift amount $\Delta d(r\uparrow)$ and an area shift amount $\Delta S(r\uparrow)$ at each lattice point are expressed as follows:
[Expression 3]

$$\Delta d\left(r\uparrow\right) = \Delta d\sin\Psi$$

$$= \Delta d\sin\left[\arg\left\{\sum_n A_n\exp\left(ik_n\uparrow\cdot r\uparrow + i\alpha_n\right)\right\}\right] \quad \cdots(3)$$

[Expression 4]

$$\Delta S\left(r\uparrow\right) = \Delta S\sin\Psi$$

$$= \Delta S\sin\left[\arg\left\{\sum_n A_n\exp\left(ik_n\uparrow\cdot r\uparrow + i\alpha_n\right)\right\}\right] \quad \cdots(4)$$

Here, $\Delta d$ and $\Delta S$ are constants, respectively, and $\Delta d(r\uparrow)$ and $\Delta S(r\uparrow)$ are functions of the variable $r\uparrow$, respectively. The values of $\Delta d$ and $\Delta S$ can be basically arbitrarily determined. However, if $\Delta d$ is too small, the positional shift amount $\Delta d(r\uparrow)$ becomes negligibly small, and thus the constant $\Delta d$ is appropriately determined so that a value of $\Delta d(r\uparrow)$ at a position where $\Delta d(r\uparrow) \neq 0$ becomes a non-negligible value (for example, 0.1 nm or more). Similarly, $\Delta S$ is appropriately determined so that a value of $\Delta S(r\uparrow)$ at a position where $\Delta S(r\uparrow) \neq 0$ becomes a non-negligible value (for example, 0.1 nm² or more).
Hereinafter, the positional shift amount $\Delta d(r\uparrow)$ will be described as an example, but the description can be similarly applied to the area shift amount $\Delta S(r\uparrow)$.
The positional shift amount $\Delta d(r\uparrow)$ expressed by Expression (3) is expressed as follows using

$$\sin[\arg C] = \text{Im}(C)/|C| \; ... \; (5),$$

which is satisfied in a general complex number C (here, Im(C) is an imaginary part of C):
[Expression 5]

$$\Delta d\left(r\uparrow\right) = \frac{\Delta d\left[\sum_n A_n \sin\left(k_n\uparrow\cdot r\uparrow + \alpha_n\right)\right]}{\sqrt{\sum_n A_n^2 + 2\sum_{m\neq m'} A_m A_{m'} \cos\left(\left(k_m\uparrow - k_{m'}\uparrow\right)\cdot r + \alpha_m - \alpha_{m'}\right)}}$$

$$\cdots(6)$$

The fact that the following:
[Expression 6]

$$2\sum_{m\neq m'} A_m A_{m'} \cos\left(\left(k_m\uparrow - k_{m'}\uparrow\right)\cdot r + \alpha_m - \alpha_{m'}\right) \quad \cdots(7)$$

of a second term of the denominator of Expression (6) has a vector $(k_m\uparrow - k_{m'}\uparrow)$ is considered to be a cause of the emission of unnecessary laser beams other than 2N laser beams corresponding to a vector $k_m\uparrow$ (m is any one of 1 to N) in the two-dimensional photonic crystal laser described in Patent Literature 3.

Therefore, in the two-dimensional photonic crystal laser according to the present invention, the second term of the denominator of Expression (6) is ignored, and a modulation value $\Delta d'(r\uparrow)$ determined by the composite period is defined as follows:
[Expression 7]

$$\Delta d'\left(r\uparrow\right) = \frac{\Delta d}{\sqrt{\sum_n A_n^2}} \sum_n A_n \sin\left(k_n\uparrow\cdot r\uparrow + \alpha_n\right) \quad \cdots(8)$$

However, in Expression (3), $\Delta d(r\uparrow)$ has the constant $\Delta d$ at a maximum possible size, whereas with the modulation value $\Delta d'(r\uparrow)$ in Expression (8), a lattice point may occur that is excessively large by ignoring the second term of the denominator of Expression (6). Therefore, in the two-dimensional photonic crystal laser according to the present invention, at a lattice point where the modulation value $\Delta d'(r\uparrow)$ obtained by Expression (8) is a value between a predetermined upper limit value $\Delta d_{max}$ and a predetermined lower limit value $\Delta d_{min}$, the modulation value $\Delta d'(r\uparrow)$ is set as the positional shift amount $\Delta d(r\uparrow)$, at a lattice point where the modulation value $\Delta d'(r\uparrow)$ exceeds the upper limit value $\Delta d_{max}$, the upper limit value $\Delta d_{max}$ is set as the positional shift amount $\Delta d(r\uparrow)$, and at a lattice point where the modulation value $\Delta d'(r\uparrow)$ is less than the lower limit value $\Delta d_{min}$, the lower limit value $\Delta d_{min}$ is set as the positional shift amount $\Delta d(r\uparrow)$. The upper limit value $\Delta d_{max}$ is typically $\Delta d$, but may be changed between 0.25 $\Delta d$ and 4.0 $\Delta d$. The lower limit value $\Delta d_{min}$ is typically $-\Delta d$, but may be changed between -4.0 $\Delta d$ and -0.25 $\Delta d$.

As described above, the above description for the positional shift amount $\Delta d(r\uparrow)$ can be similarly applied to the area shift amount $\Delta S(r\uparrow)$, so that a modulation value $\Delta S'(r\uparrow)$ determined by the composite period with respect to the area shift amount is defined as follows:
[Expression 8]

$$\Delta S'\left(r\uparrow\right) = \frac{\Delta S}{\sqrt{\sum_n A_n^2}} \sum_n A_n \sin\left(k_n\uparrow\cdot r\uparrow + \alpha_n\right) \quad \cdots(9)$$

At the lattice point where the modulation value $\Delta S'(r\uparrow)$ obtained by Expression (9) is a value between the predetermined upper limit value $\Delta S_{max}$ and the predetermined lower limit value $\Delta S_{min}$, the modulation value $\Delta S'(r\uparrow)$ is set as the area shift amount $\Delta S(r\uparrow)$; at the lattice point where the modulation value $\Delta S'(r\uparrow)$ exceeds the upper limit value $\Delta S_{max}$, the upper limit value $\Delta S_{max}$ is set as the area shift amount $\Delta S(r\uparrow)$; and at the lattice point where the modulation value $\Delta S'(r\uparrow)$ is less than the lower limit value $\Delta S_{min}$, the lower limit value $\Delta S_{min}$ is set as the area shift amount $\Delta S(r\uparrow)$. The upper limit value $\Delta S_{max}$ is typically $\Delta S$, but may be changed between 0.25 $\Delta S$ and 4.0 $\Delta S$. The lower limit value $\Delta S_{min}$ is typically $-\Delta S$, but may be changed between -4.0 $\Delta S$ and -0.25 $\Delta S$. The lower limit value $\Delta S_{min}$ and/or the reference area are/is set so that a sum of the reference area and the lower limit value $\Delta S_{min}$ is not negative.

By defining the positional shift amount $\Delta d(r\uparrow)$ and the area shift amount $\Delta S(r\uparrow)$ using the modulation value, the upper limit value, and the lower limit value, the two-dimensional photonic crystal laser according to the present invention can emit 2N laser beams corresponding to the vector $k_n\uparrow$ (n is any one of 1 to N) without including unnecessary laser beams due to a term having the vector ($k_m\uparrow$ - $k_{m'}\uparrow$) generated in the two-dimensional photonic crystal laser described in Patent Literature 3.

It is possible for the two-dimensional photonic crystal laser according to the present invention to adopt a configuration in which

the two-dimensional lattice is a first square lattice that is a square lattice,

each of the plurality of modified refractive index regions is disposed without being shifted from a first lattice point that is a lattice point of the first square lattice, and each of the plurality of modified refractive index regions has an amount of area determined by the area shift amount, and

the two-dimensional photonic crystal laser further includes a plurality of second modified refractive index regions having a refractive index different from the refractive index of the base member, wherein

each of the plurality of second modified refractive index regions is disposed without being shifted from a second lattice point that is a lattice point of a second square lattice that is a square lattice having the same period length as the first square lattice and disposed at a position different from the first square lattice, and

an amount of area of each of the second modified refractive index regions at each second lattice point is the modulation value at a modified refractive index region in which the modulation value is a value between a predetermined second upper limit value and a predetermined second lower limit value at the second lattice point, is the second upper limit value at a modified refractive index region in which the modulation value exceeds the second upper limit value, and is a value shifted from a predetermined second reference area by a second area shift amount that is the second lower limit value at a modified refractive index region in which the modulation value is less than the second lower limit value.

In a case where each of the modified refractive index region is provided only on the first lattice point, if the modified refractive index region is disposed without being shifted from the first lattice point (that is, the positional shift amount is set to 0) and only the area shift amount is modulated, a position of a node of a standing wave of an electric field formed in the two-dimensional photonic crystal layer coincides with the position of the modified refractive index region, and the intensity of the laser beam emitted from the two-dimensional photonic crystal layer becomes weak. Therefore, further, by disposing the second modified refractive index regions each having an amount of area determined by the second reference area and the second area shift amount at the second lattice point of the second square lattice disposed at a position different from the first square lattice without being shifted from the second lattice point, the second modified refractive index region exists at a position other than the node of the standing wave of the electric field, so that the intensity of the laser beam can be increased.

In order to increase the intensity of the laser beam by the above-described logic, it is most desirable to dispose the modified refractive index regions on both the first square lattice and the second square lattice without any shift from the lattice points. However, it is also allowable to dispose the modified refractive index region in one of the first square lattice and the second square lattice by shifting the modified refractive index region from the lattice point, and to apply modulation limited by the upper limit value and the lower limit value to the positional shift amount. Other modulation may be additionally applied as long as a modulation amount is small enough to hardly affect characteristics of the laser beam.

Alternatively, it is possible for the two-dimensional photonic crystal laser according to the present invention to adopt a configuration in which

the two-dimensional lattice is a first square lattice that is a square lattice,

each of the plurality of modified refractive index regions is disposed to be shifted from the first lattice point that is a lattice point of the first square lattice by the positional shift amount, and each of the plurality of modified refractive index regions has an amount of area determined by the area shift amount, and

the two-dimensional photonic crystal laser further includes a plurality of second modified refractive index regions having a refractive index different from the refractive index of the base member, wherein

each of the plurality of second modified refractive index regions is disposed without being shifted from a second lattice point that is a lattice point of a second square lattice that is a square lattice having a same period length as the first square lattice and disposed at a position different from the first square lattice, and each of the plurality of second modified refractive index regions has the same amount of area.

In a structure in which both the position and the amount of area of the modified refractive index region are modulated at the first lattice point, if the amount of area of a region where the laser oscillates is increased, the quality of the laser beam is deteriorated due to oscillation in a higher mode or the like. To further address this, the quality of the laser beam can be maintained by disposing each of the second modified refractive index region, in which the position and the amount of area are not modulated, at the second lattice point of the second square lattice disposed at the position different from the first square lattice. Modulation of the position and/or the amount of area may be additionally applied to the second modified refractive index region as long as the modulation amount(s) is small enough to hardly affect the characteristics of the laser beam.

The second reference area, the second upper limit value, and the second lower limit value may be the same values as the reference area, the upper limit value, and the lower limit value in the modified refractive index regions disposed in the first square lattice, respectively, or some or all of them may be values different from those of the modified refractive index regions.

In a configuration including the second modified refractive index region, it is preferable that the second square lattice is disposed to be shifted by 0.4 to 0.6 periods (more preferably 0.5 periods) in a same direction as one of two basic translation vectors of the first square lattice. As a result, since the second modified refractive index region is disposed in the vicinity of an antinode of a standing wave formed by the periodicity of the modified refractive index region disposed at the first lattice point, the intensity of the laser beam emitted from the two-dimensional photonic crystal layer can be increased.

In the two-dimensional photonic crystal laser according to the present invention, the positional shift amount and/or the area shift amount of each of the plurality of modified refractive index regions can be expressed by a function saturated at the upper limit value and the lower limit value, respectively, with the position of the lattice point as a variable.

For example, with the following $\sigma$ as a variable expressed using a vector $r\uparrow$ indicating the position of each lattice point ($k_n\uparrow$ and $\alpha_n$ are as described above):

[Expression 9]

$$\sigma = \sum_n \sin\left(k_n\uparrow \cdot r\uparrow + \alpha_n\right) \quad \cdots(11)$$

the function $\Delta d(\sigma)$ of the positional shift amount and the function $\Delta S(\sigma)$ of the area shift amount can be expressed as follows:

[Expression 10]

$$erf\left(\sigma\right) = \frac{2}{\sqrt{\pi}} \int_0^\sigma \exp\left(-t'^2\right) dt' \quad \cdots(27)$$

Here, t is an arbitrary constant. $\Delta d$ and $\Delta S$ are constants as described above. While $\Delta d(\sigma)$ and $\Delta S(\sigma)$ are functions of the variable $\sigma$, they are also functions of the variable $r\uparrow$ since $\sigma$ is expressed by $r\uparrow$. These functions $\Delta d(\sigma)$ and $\Delta S(\sigma)$ are saturated at the lower limit values $-\Delta d$ and $-\Delta S$ as $\sigma$ approaches negative infinity, and are saturated at the upper limit values $\Delta d$ and $\Delta S$ as $\sigma$ approaches positive infinity, respectively.

ADVANTAGEOUS EFFECTS OF INVENTION

According to the present invention, it is possible to obtain a two-dimensional photonic crystal laser that emits a large number (four or more) of laser beams while suppressing emission of unnecessary laser beams.

BRIEF DESCRIPTION OF DRAWINGS

[Fig. 1] A perspective view (a) illustrating a first embodiment of a two-dimensional photonic crystal laser according to the present invention, and a partial plan view (b) of a two-dimensional photonic crystal layer included in the two-dimensional photonic crystal laser.

[Fig. 2] A partial plan view illustrating a modification of the two-dimensional photonic crystal layer in the two-dimensional photonic crystal laser of the first embodiment, in which a direction of shift of a position of a modified refractive index region from a lattice point is different.

[Fig. 3] A partial plan view illustrating a modification of the two-dimensional photonic crystal layer in the two-dimensional photonic crystal laser of the first embodiment, in which only the position of the modified refractive index region is modulated.

[Fig. 4] A partial plan view illustrating a modification of the two-dimensional photonic crystal layer in the two-dimensional photonic crystal laser of the first embodiment, in which only an amount of area of a planar shape of the modified refractive index region is modulated.

[Fig. 5] A diagram for explaining an inclination angle and an azimuth angle of a laser beam emitted in an example of the two-dimensional photonic crystal laser of the first embodiment.

[Fig. 6] A diagram illustrating a result of calculating an intensity of a spot of a laser beam emitted in an example of the two-dimensional photonic crystal laser of the first embodiment.

[Fig. 7] A diagram illustrating a result of calculating an intensity of a spot of a laser beam emitted in a two-dimensional photonic crystal laser of a comparative example.

[Fig. 8] A diagram illustrating an example of modulating an angle ξ indicating a direction in which a position where a modified refractive index region is disposed shifts from a lattice point.

[Fig. 9] A perspective view (a) illustrating a second embodiment of a two-dimensional photonic crystal laser according to the present invention, and a partial plan view (b) of a two-dimensional photonic crystal layer included in the two-dimensional photonic crystal laser.

[Fig. 10] A diagram illustrating a result of calculating an intensity of a spot of a laser beam emitted in an example of a two-dimensional photonic crystal laser of the second embodiment.

[Fig. 11] A diagram illustrating a result obtained by calculation of an electric field distribution in the two-dimensional photonic crystal layer in an example (a) of the two-dimensional photonic crystal laser of the second embodiment, and a diagram illustrating a result obtained by calculation of an electric field distribution in the two-dimensional photonic crystal layer in an example (b) in which only an amount of area is modulated in the two-dimensional photonic crystal laser of the first embodiment.

[Fig. 12] A partial plan view illustrating a modification of the two-dimensional photonic crystal layer in the two-dimensional photonic crystal laser of the second embodiment.

[Fig. 13] A photograph showing a far-field image formed by a laser beam using the two-dimensional photonic crystal laser of a third embodiment.

[Fig. 14] A graph showing a result of experimentally obtaining a relationship between a peak light output and a magnitude of an electric current for each of the two-dimensional photonic crystal laser of the third embodiment and a conventional two-dimensional photonic crystal laser in which the far-field image shown in Fig. 13 is formed.

[Fig. 15] A graph showing an example of a function of an area shift amount $\Delta S(\sigma)$ in an example of a two-dimensional photonic crystal laser of a fourth embodiment.

[Fig. 16] A graph illustrating an example of a change with $\sigma$ in an area shift amount $\Delta S(\sigma)$ in the example of the two-dimensional photonic crystal laser of the first embodiment, to which the function of Fig. 15 is approximated.

[Fig. 17] A diagram illustrating a result of calculating an intensity of a spot of a laser beam emitted in an example of the two-dimensional photonic crystal laser of the fourth embodiment.

DESCRIPTION OF EMBODIMENTS

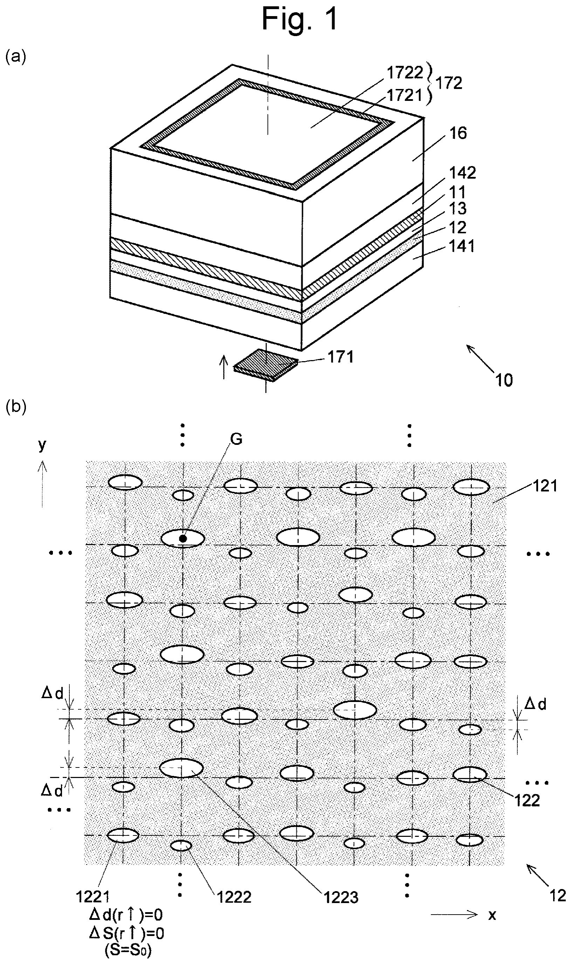

Embodiments of a two-dimensional photonic crystal laser according to the present invention will be described with reference to Figs. 1 to 17.

(1) First Embodiment

As illustrated in Fig. 1(a), a two-dimensional photonic crystal laser 10 of the first embodiment has a configuration in which a first electrode 171, a first cladding layer 141, a two-dimensional photonic crystal layer 12, a spacer layer 13, an active layer 11, a second cladding layer 142, a substrate 16, and a second electrode 172 are sequentially stacked in the above-described order. However, the order of the active layer 11 and the two-dimensional photonic crystal layer 12 may be opposite to that described above. In Fig. 1(a), for convenience, the first electrode 171 is illustrated as a lower side, and the second electrode 172 is illustrated as an upper side. However, the orientation of the two-dimensional photonic crystal laser 10 at the time of use is not limited to that illustrated in Fig. 1(a). Hereinafter, configurations of the layers and the electrodes will be described.

The active layer 11 emits light having a specific wavelength band upon being supplied with electric charges from the first electrode 171 and the second electrode 172. As a material of the active layer 11, for example, an InGaAs/AlGaAs multiple quantum well (emission wavelength band: 935 to 945 nm) can be used.

As illustrated in Fig. 1(b), in the two-dimensional photonic crystal layer 12, modified refractive index regions 122 having a refractive index different from that of a plate-shaped base member 121 are disposed, one by one in relation to lattice points of a two-dimensional lattice, in the plate-shaped base member 121. In Fig. 1(b), only a part of the two-dimensional photonic crystal layer 12 is illustrated in an enlarged manner, and in an actual two-dimensional photonic crystal layer 12, a large number of modified refractive index regions 122 are disposed over a range equivalent to an outer edge of a planar shape of the second electrode 172. For example, p-type GaAs (p-type semiconductor) can be used as a material of the base member 121. Although a hole is typically used for the modified refractive index region 122, a member having a refractive index different from a refractive index of the base member 121 may be used instead of the hole. A position where the modified refractive index region 122 is disposed and a planar shape of the modified refractive index region 122 will be described in detail later.

The first cladding layer 141 and the second cladding layer 142 have the role of supplying electric charges from the first electrode 171 and the second electrode 172, and the role of inhibiting in-plane guided light guided in parallel to the layer within the two-dimensional photonic crystal layer 12 from leaking from the layer. In order to play the former role, a p-type semiconductor (for example, p-type $Al_{0.37}Ga_{0.63}As$) is used for the first cladding layer 141, and an n-type semiconductor (for example, n-type $Al_{0.37}Ga_{0.63}As$) is used for the second cladding layer 142 (the reason why the p-type semiconductor is used as the material of the base member 121 of the two-dimensional photonic crystal layer 12 is also the same as above).

The spacer layer 13 is provided to inhibit electrons supplied from the second electrode 172 from passing through the active layer 11 (to combine with positive holes on a first electrode 171 side of the active layer 11) while allowing positive holes supplied from the first electrode 171 to pass through and to be introduced into the active layer 11. For example, p-type $Al_{0.45}Ga_{0.55}As$ can be used as a material of the spacer layer 13.

The substrate 16 having a sufficiently larger thickness than the other layers is used in order to maintain a mechanical strength of an entire two-dimensional photonic crystal laser 10. As a material of the substrate 16, an n-type semiconductor is used for the same reason as that of the second cladding layer 142.

In the first embodiment, the first electrode 171 is formed of a square metal plate-shaped member. In the first embodiment, the second electrode 172 is formed by hollowing out the center of a square metal plate-shaped member having a side longer than that of the first electrode 171 into a square shape. A portion of the second electrode 172 where the plate-shaped member is hollowed out is referred to as a window portion 1722, and a portion where the plate-shaped member is left is referred to as a frame portion 1721. The window portion 1722 is provided to allow a laser beam oscillated from the two-dimensional photonic crystal layer 12 to pass through as described later. In Fig. 1(a), the first electrode 171 and the first cladding layer 141 are separated from each other to illustrate a shape of the first electrode 171, but the first electrode 171 and the first cladding layer 141 are actually in contact with each other.

The materials of each layer described so far are examples, and other materials may be used. Shapes of the first electrode 171 and the second electrode 172 are not limited to those described above, and other shapes (for example, a first electrode including a circular metal plate-shaped member and a second electrode in which the center of a circular metal plate-shaped member having a diameter larger than that of the first electrode is hollowed out in a circular shape) may be used.

Hereinafter, the position where the modified refractive index region 122 is disposed in the two-dimensional photonic crystal layer 12 and the planar shape of the modified refractive index region 122 will be described in detail.

In the example illustrated in Fig. 1(b), the modified refractive index region 122 is disposed such that a center of gravity G of the planar shape of the modified refractive index region 122 is located at a position shifted in a y direction by a predetermined positional shift amount from a lattice point, which is an intersection of an alternate dot and dash line extending in an x direction (horizontal direction in the same drawing) and an alternate dot and dash line extending in the y direction (vertical direction in the same drawing), in the square lattice indicated by an alternate dot and dash line in the same drawing. The positional shift amount is different for each modified refractive index region 122 (lattice point) as described later. The planar shape of each of the modified refractive index regions 122 is an elliptical shape with the x direction as a major axis, and the amount of area (area shift amount to be described later) is also different for each of the modified refractive index regions 122. A lattice point period (length) a of the square lattice is appropriately determined according to a material of the base member 121 and the emission wavelength band in the active layer 11. Instead of the square lattice, another two-dimensional lattice such as a rectangular lattice or a triangular lattice may be used. The planar shape including the positional shift amount and the amount of area of the modified refractive index region 122 can also be various modified, and modifications thereof will be described later.

Here, after introducing the following value $\sigma$, the positional shift amount at each lattice point expressed by a position vector $r{\uparrow}$ of each lattice point is determined. $\sigma$ is expressed as follows:
[Expression 11]

$$\sigma = \sum_{n} \sin\left(k_n{\uparrow} \cdot r{\uparrow} + \alpha_n\right) \quad \cdots(11)$$

Here, $k_n{\uparrow}$ is a wave number vector determined by a combination of an inclination angle and an azimuth angle in each of N (N is an integer of 2 or more; n is any value of 1 to N) laser beams having different inclination angles $\theta_n$ and/or azimuth angles $\varphi_n$ as described above, and is expressed by Expression (2) since a square lattice is used in the first embodiment. In the first embodiment, a positional shift amount $\Delta d(r{\uparrow})$ at each lattice point was as follows:
[Expression 12]

$$\Delta d\left(r\uparrow\right) = \Delta d\frac{\sigma}{\sqrt{N}} \quad \left(|\sigma| \leq \sqrt{N}\right)$$
$$\Delta d \quad \left(\sigma > \sqrt{N}\right)$$
$$-\Delta d \quad \left(\sigma < \sqrt{N}\right)$$

$$\cdots(12)$$

The right side in the first line of Expression (12) defines an amplitude $A_n$ as 1 regardless of a value of n in a modulation amount $\Delta d'(r\uparrow)$ determined by a composite period shown in Expression (8). Setting the amplitude $A_n$ to 1 regardless of the value of n is not an essential requirement in the present invention, and is merely an example of the present invention. In the second and third lines of Expression (12), an upper limit value of the positional shift amount $\Delta d(r\uparrow)$ is defined as a constant $+\Delta d$, and a lower limit value is defined as a constant $-\Delta d$. In the right side of the expression in the first line of Expression (12), when $\sigma$ is set to $N^{1/2}$ that is the upper limit value and $-N^{1/2}$ that is the lower limit value to which the expression in the first line is applied, the values of $\Delta d(r\uparrow)$ are $+\Delta d$ and $-\Delta d$, respectively, and coincide with the values in the second line and the third line, respectively.

As described above, in the first embodiment, the upper limit value $\Delta d_{max} = \Delta d$ and the lower limit value $\Delta d_{inx} = -\Delta d$ are set to the positional shift amount determined by the composite period, and the positional shift of the amount deviating from a range between the upper limit value and the lower limit value is prevented from occurring. In the first embodiment, since the modified refractive index region 122 is shifted in the y direction, a positive and negative of $\Delta d(r\uparrow)$ express a positive and negative in the y direction.

An amount of area $S(r\uparrow)$ of the planar shape of the modified refractive index region 122 is a sum of a predetermined reference area $S_0$ independent of the position of the lattice point and an area shift amount $\Delta S(r\uparrow)$ expressing the shift from the reference area $S_0$, and is expressed as follows:

$$S(r\uparrow) = S_0 + \Delta S(r\uparrow) \dots (13)$$

Similarly to the positional shift amount $\Delta d(r\uparrow)$, the area shift amount $\Delta S(r\uparrow)$ is expressed as follows:
[Expression 13]

$$\Delta S\left(r\uparrow\right) = \Delta S\frac{\sigma}{\sqrt{N}} \quad \left(|\sigma| \leq \sqrt{N}\right)$$
$$\Delta S \quad \left(\sigma > \sqrt{N}\right)$$
$$-\Delta S \quad \left(\sigma < \sqrt{N}\right)$$

$$\cdots(14)$$

As described above, the area shift amount $\Delta S(r\uparrow)$ is also determined by the modulation amount determined by the composite period based on a linear sum of sine functions included in $\sigma$ on the right side in the first line of Expression (14), the upper limit value $+\Delta S$, and the lower limit value $-\Delta S$, so that the area shift of an amount exceeding the upper limit value does not occur. The reference area $S_0$ is set to a value larger than $\Delta S$ so as not to generate a modified refractive index region 122 in which a value of $S(r\uparrow)$ becomes negative. On the other hand, if the reference area $S_0$ is too large, adjacent modified refractive index regions 122 overlap each other, and thus, the reference area $S_0$ is determined so as not to cause such overlapping.

Since the positional shift amount $\Delta d(r\uparrow)$ expressed by Expression (12) and the area shift amount $\Delta S(r\uparrow)$ expressed by Expression (14) are defined by the same $\sigma$, they have the same composite period. Therefore, as illustrated in Fig. 1(b), the area shift amount $\Delta S(r\uparrow)$ of a modified refractive index region 1221 ($\Delta d(r\uparrow) = 0$) at the lattice point also becomes 0 (therefore, an amount of area S is $S_0$); at a modified refractive index region 1222 ($\Delta d(r\uparrow) > 0$) disposed to be shifted from the lattice point in a positive direction with respect to the y direction, the area shift amount $\Delta S(r\uparrow)$ becomes positive ($S > S_0$); and at a modified refractive index region 1223 ($\Delta d(r\uparrow) < 0$) disposed to be shifted from the lattice point in a negative direction with respect to the y direction, the area shift amount $\Delta S(r\uparrow)$ becomes negative ($S < S_0$).

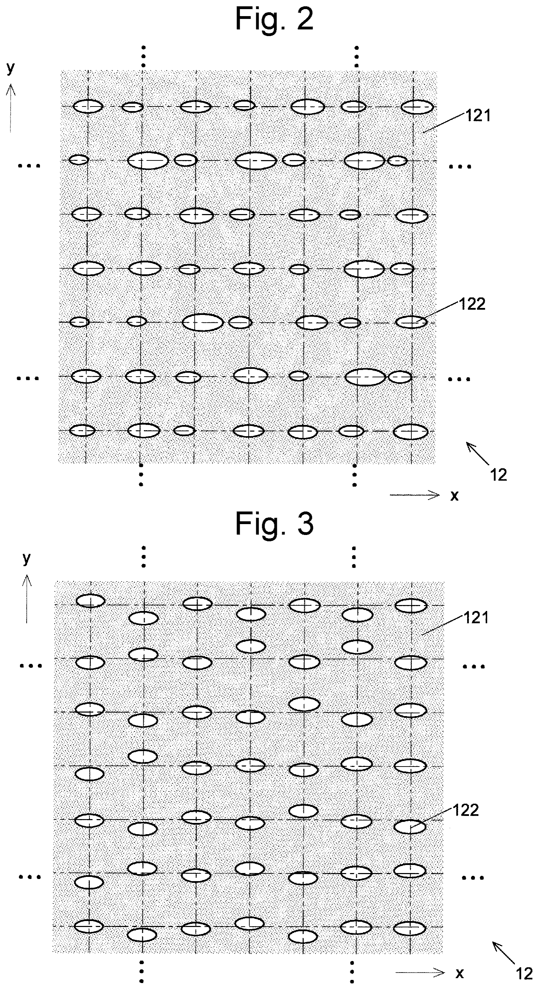

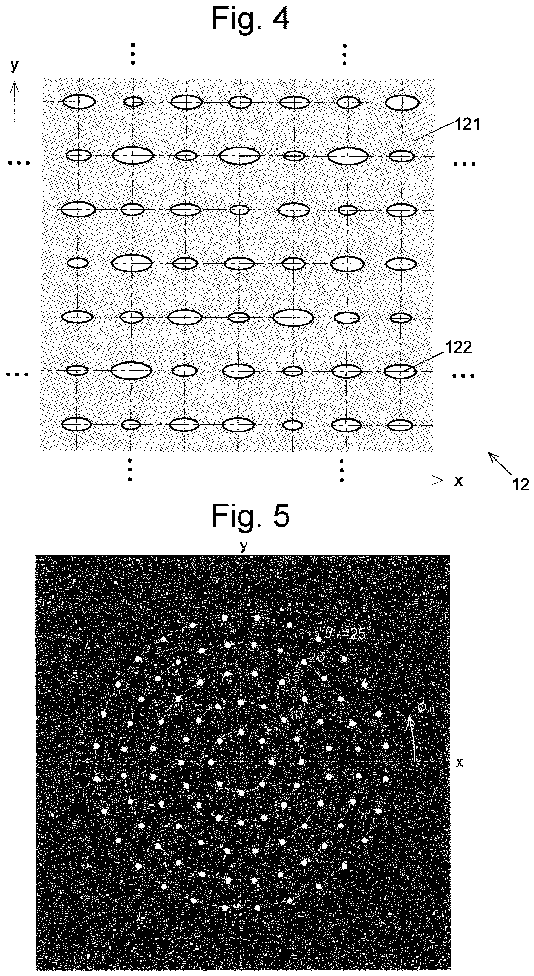

In the example illustrated so far, the position of the modified refractive index region 122 is modulated so as to be shifted in the y direction from the lattice point, but may be modulated so as to be shifted in another direction. In the example illustrated in Fig. 2, the major axis of the elliptical shape of the modified refractive index region 122 is oriented in the x direction as in Fig. 1(b), and the direction of the positional shift is set to the x direction. As illustrated in Fig. 3, only the positional shift amount may be modulated without modulating the amount of area of the planar shape (using a modified refractive index region 122 having the same amount of area). Alternatively, as illustrated in Fig. 4, only the amount of area of the planar shape may be modulated without modulating the positional shift amount (disposing the modified refractive index region 122 at a lattice point).

Next, results obtained by calculating the intensity of the emitted laser beam for the two-dimensional photonic crystal laser 10 of the first embodiment will be described. In this calculation example, the intensity of the spot of the laser beam incident on a face parallel to the two-dimensional photonic crystal layer 12 away from the second electrode 172 by a predetermined distance in a direction perpendicular to the layer was obtained. In this calculation example, 50 types (N = 50) of vectors $k_n\uparrow$ in which combinations $(\theta_n, \varphi_n)$ of $\theta_n$ and $\varphi_n$ in Expression (2) are (5°, 0°), (5°, 45°), (5°, 90°), (5°, 135°), (10°, 0°), (10°, 22.5°), (10°, 45°), (10°, 67.5°), (10°, 90°), (10°, 112.5°), (10°, 135°), (10°, 157.5°), (15°, 9°), (15°, 27°), (15°, 45°), (15°, 63°), (15°, 81°), (15°, 99°), (15°, 117°), (15°, 135°), (15°, 153°), (15°, 171°), (20°, 6.4°), (20°, 19.3°), (20°, 32.1°), (20°, 45°), (20°, 57.9°), (20°, 70.7°), (20°, 83.6°), (20°, 96.4°), (20°, 109.3°), (20°, 122.1°), (20°, 135°), (20°, 147.9°), (20°, 160.7°), (20°, 173.6°), (25°, 6.4°), (25°, 19.3°), (25°, 32.1°), (25°, 45°), (25°, 57.9°), (25°, 70.7°), (25°, 83.6°), (25°, 96.4°), (25°, 109.3°), (25°, 122.1°), (25°, 135°), (25°, 147.9°), (25°, 160.7°), and (25°, 173.6°), respectively, were set. As illustrated in Fig. 5, these vectors $k_n\uparrow$ act so as to emit a total of 8 laser beams with an inclination angle $\theta_n$ = 5° at every azimuth angle $\varphi_n$ = 45°, a total of 16 laser beams with $\theta_n$ = 10° at every $\varphi_n$ = 22.5°, a total of 20 laser beams with $\theta_n$ = 15° at every $\varphi_n$ = 18°, a total of 28 laser beams with $\theta_n$ = 20° at every $\varphi_n$ = (180/14)°, and a total of 28 laser beams with $\theta_n$ = 25° at every $\varphi_n$ = (180/14)°. The total number of emitted laser beams is 100 (= 2N).

When these vectors $k_n\uparrow$ are applied to Expression (11), $\sigma$ is expressed by a linear sum of sine functions of N = 50 terms. In this calculation example, Expression (12) and Expression (14) are calculated as $\Delta d = 0.08a$ (that is, the upper limit value of the positional shift amount is 8% of a lattice constant a of the square lattice), $S_0 = 0.095a^2$ (that is, $S_0$ is 9.5% of the amount of area $a^2$ of a unit lattice of the square lattice), and $\Delta S = 0.03a^2$ (that is, the upper limit value of the area shift amount is 3% of the amount of area $a^2$ of the unit lattice of the square lattice).

As a comparative example, the same 50 types of vectors $k_n\uparrow$ as in the above calculation example were set, $S_0 = 0.095a^2$ was set, and the intensity of the spot of the laser beam was also calculated for a laser beam to which composite modulation was applied without setting the upper limit value $+\Delta d$ and the lower limit value $-\Delta d$ of the positional shift amount and the upper limit value $+\Delta S$ and the lower limit value $-\Delta S$ of the area shift amount. This comparative example corresponds to the two-dimensional photonic crystal laser of Patent Literature 3. However, in this calculation, an electric current to be supplied is made larger than that in the calculation performed in Patent Literature 3, whereby the intensity of the laser beam is also increased. In the calculation of the first embodiment, an electric current having the same magnitude as that of the comparative example is set.

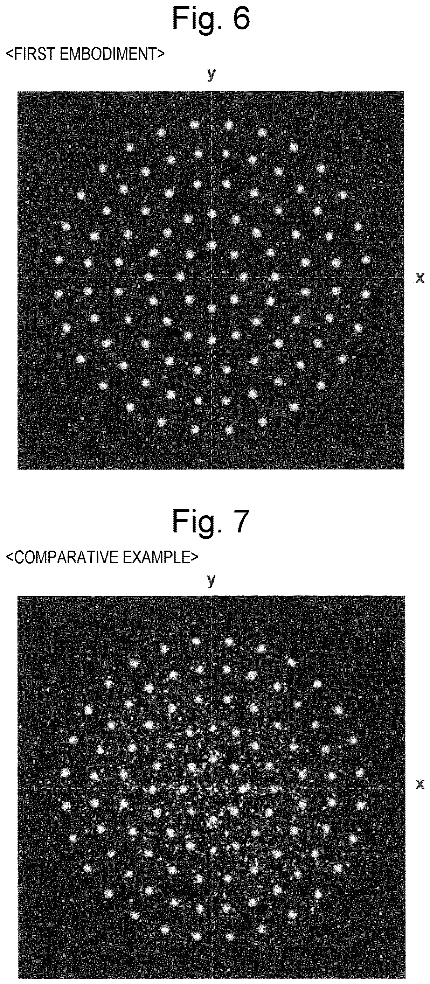

Fig. 6 illustrates a calculation result of the first embodiment, and Fig. 7 illustrates a calculation result of the comparative example. In the comparative example, in addition to a position of a proper spot of the laser beam illustrated in Fig. 5, there are many spots of laser beams weaker than the proper spot. In these weak laser beams, as a result of increasing the electric current to be supplied, unnecessary laser beams, which were negligibly weak in Patent Literature 3, became conspicuous. On the other hand, in Fig. 6, unnecessary laser beams are hardly observed, and it can be seen that the emission of such unnecessary laser beams is suppressed in the first embodiment.

Also in the first embodiment, a weak unnecessary laser beam that can be ignored is emitted in Fig. 6. When a sum of the intensities of the unnecessary laser beams is expressed as a ratio to a sum of the intensities of all the laser beams (including the proper laser beam and unnecessary laser beams), this ratio is 23.9% in the comparative example, whereas the ratio is 8.5% in the first embodiment, and it has also been confirmed in numerical values of calculation that emission of unnecessary laser beams is suppressed in the first embodiment.

The two-dimensional photonic crystal laser of the first embodiment can be variously modified in addition to modifications in which a periodic structure of the two-dimensional photonic crystal layer illustrated in Figs. 2 to 4 is changed. For example, in the above embodiment, the planar shape of the modified refractive index region is an elliptical shape, but various shapes such as an equilateral triangle, other triangles, a polygon of a quadrangle or more, a circle, and an indefinite shape may be used. Further, one modified refractive index region may be a combination of a plurality of holes or members different from the base member.

The positional shift amount $\Delta d(r\uparrow)$ expressed by Expression (12) is obtained by setting the value of $A_n$ in Expression (8) to 1 for every n, but the value of $A_n$ may be set (including a value other than 1) for each n. The same applies to the area shift amount $\Delta S(r\uparrow)$ expressed by Expression (14).

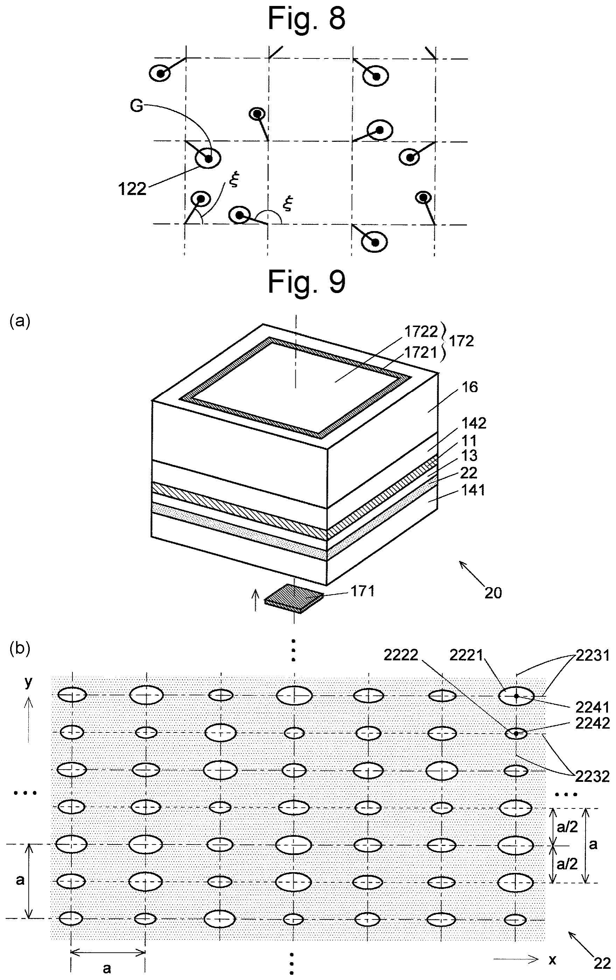

In the example illustrated so far, the positional shift amount is one of the two directions (the x direction and the y direction), in which the lattice points of the square lattice are arranged. However, the positional shift amount may be disposed so as to be shifted from the lattice points in other directions. Furthermore, in the example illustrated so far, a distance from the lattice point is set as the positional shift amount, but instead of or in addition to this, an angle $\xi$ (see Fig. 8; in the drawing, the x direction is set as a reference direction) formed by a direction shifted from the lattice point with respect to a predetermined reference direction (for example, the x direction or the y direction) may be set as the positional shift amount (that is, the angle $\xi$ is different for each lattice point).

In the example illustrated in Fig. 1(b), 2N laser beams are emitted by determining a positional shift amount $\Delta(r\uparrow)$ and the area shift amount $\Delta S(r\uparrow)$ using the same vector $k_n\uparrow$ (n is any one of 1 to N), but the positional shift amount $\Delta(r\uparrow)$ may be determined using the vector $k_n\uparrow$ (n is any one of 1 to N), and the area shift amount $\Delta S(r\uparrow)$ may be determined using a vector $k_m\uparrow$ (m is any of 1 to M, and M may be the same as or different from N) different from $k_n\uparrow$.

(2) Second Embodiment

As illustrated in Fig. 9, a two-dimensional photonic crystal laser 20 of a second embodiment has the same configuration as that of the two-dimensional photonic crystal laser 10 of the first embodiment except that a configuration of a two-dimensional photonic crystal layer 22 is different from the configuration of the two-dimensional photonic crystal layer 12 in the two-dimensional photonic crystal laser 10 of the first embodiment. Therefore, only the configuration of the two-dimensional photonic crystal layer 22 will be described below.

In the two-dimensional photonic crystal layer 22, a first modified refractive index region 2221 and a second modified refractive index region 2222 having a refractive index different from that of a plate-like base member 221 are periodically disposed in the base member 221. The first modified refractive index region 2221 and the second modified refractive index region 2222 are both holes (air) in the present embodiment, but may be made of a member (other than air) different from the base member 221. When such a member is used, members made of the same material or members made of different materials may be used for the first modified refractive index region 2221 and the second modified refractive index region 2222.

The first modified refractive index region 2221 is disposed such that the center of gravity of the planar shape coincides with a first lattice point 2241 that is the lattice point of a first square lattice 2231 that is the square lattice of the period a indicated by the alternate dot and dash line extending in the x direction and the alternate dot and dash line extending in the y direction in Fig. 9(b). The second modified refractive index region 2222 is disposed such that the center of gravity of the planar shape coincides with a second lattice point 2242 that is the lattice point of a second square lattice 2232 that is the square lattice of the period a indicated by the broken line extending in the x direction and the alternate dot and dash line extending in the y direction in Fig. 9(b) (the latter is common to the first square lattice 2231). That is, the first modified refractive index region 2221 and the second modified refractive index region 2222 are disposed at lattice points of the square lattice shifted from each other by a/2 in the y direction.

Each of the first modified refractive index regions 2221 has an elliptical planar shape, and an amount of area $S_1(r\uparrow)$ of the elliptical planar shape is expressed by a sum of a first reference area $S_{01}$ independent of the first modified refractive index region 2221 (lattice point) and an area shift amount $\Delta S_1(r\uparrow)$ depending on a position vector $r\uparrow$ of the first modified refractive index region 2221 (lattice point) as follows:

$$S_1(r\uparrow) = S_{01} + \Delta S_1(r\uparrow) \ ... \ (15)$$

$\Delta S_1(r\uparrow)$ is expressed as follows using $\sigma$ expressed in Expression (11) and a first upper limit value $\Delta S_1$, which is an upper limit value of the amount of area of the first modified refractive index region 2221:

[Expression 14]

$$\Delta S_1(r\uparrow) = \begin{array}{ll} \Delta S_1 \dfrac{\sigma}{\sqrt{N}} & \left(|\sigma| \leq \sqrt{N}\right) \\ \Delta S_1 & \left(\sigma > \sqrt{N}\right) \\ -\Delta S_1 & \left(\sigma < \sqrt{N}\right) \end{array}$$

$$\cdots(16)$$

Therefore, a first lower limit value is $-\Delta S_1$.

In addition, each of the second modified refractive index regions 2222 has an elliptical planar shape, and an amount of area $S_2(r\uparrow)$ of the elliptical planar shape is expressed by a sum of a second reference area $S_{02}$ independent of the second modified refractive index region 2222 (lattice point) and an area shift amount $\Delta S_2(r\uparrow)$ depending on a position vector $r\uparrow$ of the second modified refractive index region 2222 (lattice point), as follows:

[Expression 15]

$$S_2(r\uparrow) = S_{02} + \Delta S_2(r\uparrow) \ ... \ (17)$$

$\Delta S_2(r\uparrow)$ is expressed as follows using $\sigma$ expressed in Expression (11) and a second upper limit value $\Delta S_2$, which is an upper limit value of the amount of area of the first modified refractive index region 2221:

$$\Delta S_2\,(r\uparrow) = \Delta S_2 \frac{\sigma}{\sqrt{N}} \quad \left(|\sigma| \le \sqrt{N}\right)$$
$$\Delta S_2 \quad \left(\sigma > \sqrt{N}\right)$$
$$-\Delta S_2 \quad \left(\sigma < \sqrt{N}\right)$$

$$\cdots(18)$$

Therefore, a second lower limit value is $-\Delta S_2$. The first reference area $S_{01}$, and the second reference area $S_{02}$ may have the same value or different values. The first upper limit value $\Delta S_1$ and the second upper limit value $\Delta S_2$ may be the same value or different values.

Next, results obtained by calculating the intensity of the emitted laser beam for the two-dimensional photonic crystal laser 20 of the second embodiment will be described. In this calculation example, 12 types (N = 12) of vectors $k_n\uparrow$ in which combinations $(\theta_n, \varphi_n)$ of $\theta_n$ and $\varphi_n$ in Expression (2) are (11°, 0°), (11°, 90°), (23°, 0°), (23°, 90°), (36°, 0°), (36°, 90°), $(11 \times 2^{1/2°}, 45°)$, $(11 \times 2^{1/2°}, 135°)$, $(23 \times 2^{1/2°}, 45°)$, $(23 \times 2^{1/2°}, 135°)$, $(36 \times 2^{1/2°}, 45°)$, and $(36 \times 2^{1/2°}, 135°)$, respectively, were set. These vectors $k_n\uparrow$ act to emit four laser beams with inclination angles $\theta_n$ = 11°, 23°, and 36° at azimuth angles $\varphi_n$ = 0°, 90°, 180°, and 270°, respectively, and to emit four laser beams with inclination angles $\theta_n = 11 \times 2^{1/2°}$, $23 \times 2^{1/2°}$, and $36 \times 2^{1/2°}$ at azimuth angles $\varphi_n$ = 45°, 135°, 225°, and 305°, respectively, for a total of 24 (2N). The parameters in Expression (16) and Expression (18) are as follows: the first reference area $S_{01}$ is $0.075a^2$, the second reference area $S_{02}$ is $0.055a^2$, the first upper limit value $\Delta S_1$ is $0.03a^2$, and the second upper limit value $\Delta S_2$ is $0.025a^2$.

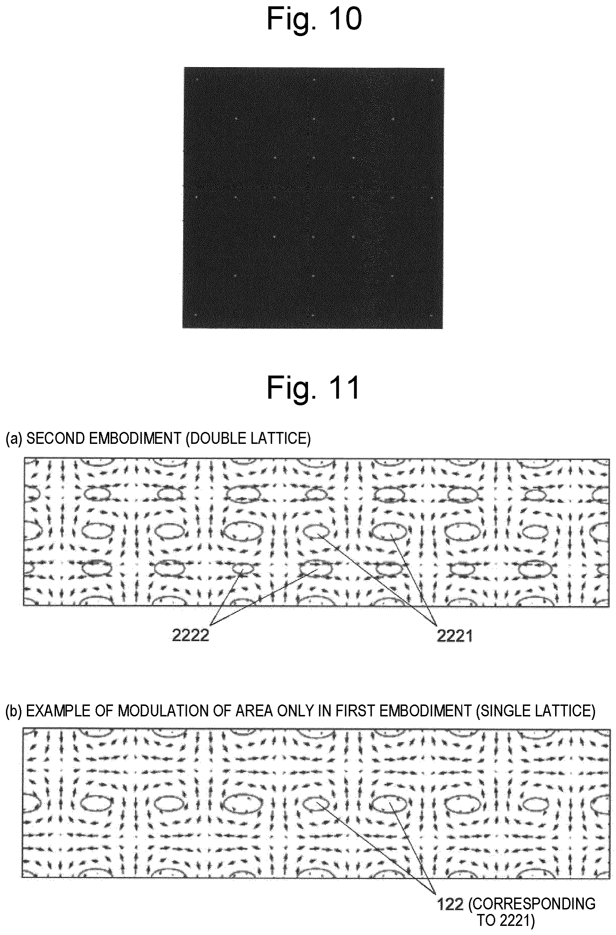

Fig. 10 illustrates the calculation results. 24 spots of laser beams are obtained, and no other spots are observed. However, since negligibly weak unnecessary laser beams are actually emitted in Fig. 10, when the sum of the intensities of the unnecessary laser beams was obtained as a ratio to the sum of the intensities of all the laser beams, the ratio was 22%.

As a comparative example, calculation was performed for a comparative example using the first modified refractive index region 2221 in which only the amount of area was modulated based on Expression (4) without providing the upper limit value and the lower limit value, and the second modified refractive index region 2222 having a second reference area $S_{02}$ = $0.055a^2$ without modulating both the position and the amount of area. Here, in the first modified refractive index region 2221, to correspond to the example of the second embodiment, $A_n$ = 1 was set for every n in Expression (4), and the constant $\Delta S$ was set to a first upper limit value $\Delta S_1$ = $0.03a^2$. In this comparative example, the sum of the intensities of the unnecessary laser beams was obtained as a ratio to the sum of the intensities of all the laser beams, and the ratio was 4.7%. As described above, in the second embodiment, it was confirmed that emission of unnecessary laser beams is suppressed as compared with the comparative example.

Fig. 11 illustrates a result obtained by calculating an electric field distribution in the two-dimensional photonic crystal layer for an example (a) of the two-dimensional photonic crystal laser of the second embodiment and an example (b) of the two-dimensional photonic crystal laser of the first embodiment in which only the amount of area is modulated. The example (b) corresponds to a configuration in which only the first modified refractive index region 2221 is provided (excluding the second modified refractive index region 2222) in the two-dimensional photonic crystal layer 22 of the two-dimensional photonic crystal laser of the example (a). Directions and lengths of many arrows shown in these drawings indicate the directions and the magnitudes of the electric fields at the positions of the arrows. Both (a) and (b) indicate that the electric field becomes small in the vicinity of the first modified refractive index region 2221. On the other hand, as illustrated in (a), the electric field is larger in the vicinity of the second modified refractive index region 2222 than in the vicinity of the first modified refractive index region 2221. As a result, the example of (a) is more likely to emit a laser beam to the outside of the two-dimensional photonic crystal layer than the example of (b).

In the second embodiment, various modifications are also possible. For example, the shapes of the first modified refractive index region 2221 and the second modified refractive index region 2222 are not limited to the elliptical shape, and can take various shapes, as in the example described in the first embodiment. The direction and size of the shift between the first square lattice and the second square lattice are not limited to the above example (1/2a in the y direction), and can be set to various directions and sizes.

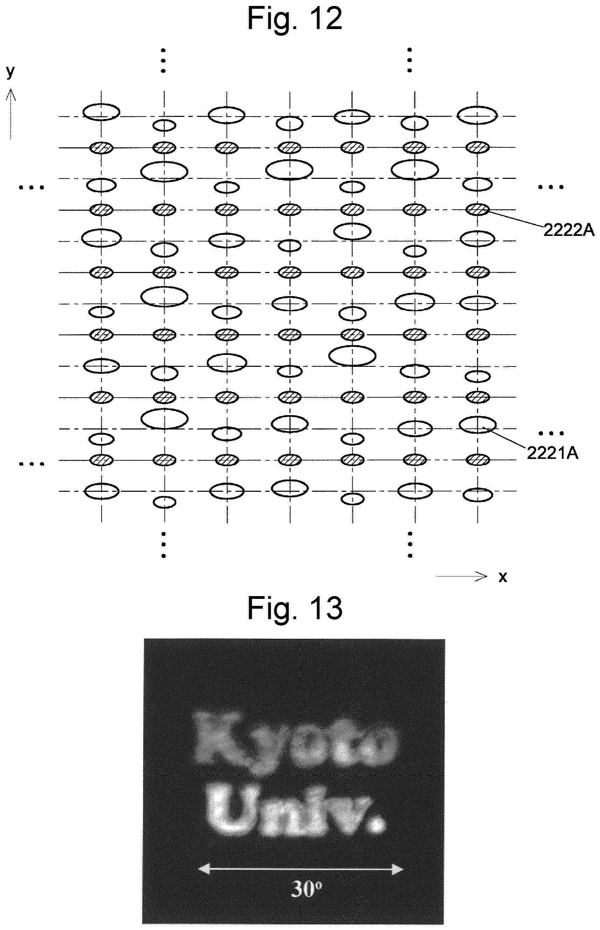

As illustrated in Fig. 12, a first modified refractive index region 2221A may be disposed so as to have a predetermined positional shift amount and a predetermined area shift amount at each first lattice point of the first square lattice (square lattice indicated by vertical and horizontal alternate dot and dash lines in Fig. 12), and a second modified refractive index region 2222A may be disposed so as not to have a positional shift and an area shift at each second lattice point of the second square lattice (square lattice indicated by horizontal alternate two-dot and dash lines and vertical alternate dot and dash lines in Fig. 12). As a result, even if the amount of area of a region where the laser oscillates is increased, it is possible to maintain the quality of the laser beam by preventing oscillation in a higher mode and the like. Fig. 12 illustrates an example in which the second square lattice is disposed to be shifted from the first square lattice by a 1/2 period in the longitudinal direction of the drawing, but the magnitude and direction of this shift are arbitrary.

(3) Third Embodiment

Hitherto, embodiments of a two-dimensional photonic crystal laser that emits a large number of laser beams while suppressing emission of unnecessary laser beams have been described. However, as described in Patent Literature 3, if the number of laser beams is sufficiently increased, it is possible to form a distribution of laser spots indicating various patterns such as a pattern for uniformly irradiating a wide angular range and a pattern expressing a character or a figure. Even in such a case, a method of setting the upper limit value and the lower limit value to the positional shift amount and the area shift amount of the modified refractive index region can be used.

An electric field distribution in a wave number space corresponding to a distribution (far-field image) of a laser spot to be formed at a position distant from the two-dimensional photonic crystal laser is defined as a target far electric field distribution $E_{far\_iFFT}(K\uparrow)$, and an electric field distribution (near-field image) in a real space in a cross section parallel to the two-dimensional photonic crystal layer of the two-dimensional photonic crystal laser in the layer of a laser beam to be emitted from the two-dimensional photonic crystal layer is defined as a target radiated electric field distribution $E_{rad\_iFFT}(r\uparrow)$ in order to form such a target far electric field distribution $E_{far\_iFFT}(K\uparrow)$. The target radiated electric field distribution $E_{rad\_iFFT}(r\uparrow)$ is obtained as follows by Expression (21) by performing inverse Fourier transform on the target far electric field distribution $E_{far\_iFFT}(K\uparrow)$ using a correction coefficient $A(K\uparrow)$ that is a complex number:

[Expression 16]

$$E_{\mathrm{rad\_iFFT}}(r\uparrow) = \mathrm{C} \int\int \mathrm{A}(K\uparrow) E_{\mathrm{far\_iFFT}}(K\uparrow)\exp(iK\uparrow\cdot r\uparrow)\,\mathrm{d}K\uparrow \quad \cdots(21)$$

Therefore, a modulation phase $\Psi(r\uparrow)$ for each position $r\uparrow = (x, y)$ of the lattice points at which the modified refractive index regions are disposed is adjusted such that a radiated electric field distribution $E_{rad}(r\uparrow)$ obtained from the modulation phase $\Psi(r\uparrow)$ of the modified refractive index region for each position $r\uparrow = (x, y)$ approaches the target radiated electric field distribution $E_{rad\_iFFT}(r\uparrow)$ obtained by Expression (21). For example, Expression (21) is applied to Expression (22) below

[Expression 17]

$$\Psi(r\uparrow) = \arcsin\left[\pm\frac{\mathrm{Real}\left[E_{\mathrm{rad\_iFFT}}(r\uparrow)\right]}{\mathrm{Max}\left\{\mathrm{Real}\left[E_{\mathrm{rad\_iFFT}}(r\uparrow)\right]\right\}}\right] \quad \cdots(22)$$

so that the modulation phase $\Psi(r\uparrow)$ after adjustment can be determined (see Patent Literature 3).

The positional shift amount $\Delta d(r\uparrow)$ without considering the upper limit value and the lower limit value is expressed by the following Expression (23):

$$\Delta d(r\uparrow) = B\cdot\Delta d\cdot\sin(\Psi(r\uparrow)) \ldots (23)$$

Here, $B\cdot\Delta d$ is a positive constant, but is expressed by a product of B, which is a constant larger than 1, and a value $\Delta d$, which is set as an upper limit value and a lower limit value in the following Expression (24).

If the upper limit value $\Delta d$ and the lower limit value $-\Delta d$ are applied to Expression (23), the positional shift amount $\Delta d(r\uparrow)$ is expressed by Expression (24):

$$\Delta d(r\!\uparrow) = B\cdot\Delta d\cdot\sin(\Psi(r\!\uparrow)) \ (\text{when}|B\cdot\sin(\Psi(r\!\uparrow))|\leq 1)$$

$$\Delta d \ (\text{when } B\cdot\sin(\Psi(r\!\uparrow) > 1)$$

$$-\Delta d \ (\text{when } B\cdot\sin(\Psi(r\!\uparrow) < -1) \ ... \ (24)$$

Similarly, the area shift amount $\Delta S(r\!\uparrow)$ is expressed by the following Expression (25) by applying C, which is a constant larger than 1, the upper limit value $\Delta S$, and the lower limit value $-\Delta S$:

$$\Delta S(r\!\uparrow) = C\cdot\Delta S\cdot\sin(\Psi(r\!\uparrow)) \ (\text{when}|C\cdot\sin(\Psi(r\!\uparrow))|\leq 1)$$

$$\Delta S \ (\text{when } C\cdot\sin(\Psi(r\!\uparrow) > 1)$$

$$-\Delta S \ (\text{when } C\cdot\sin(\Psi(r\!\uparrow) < -1) \ ... \ (25)$$

The amount of area $S(r\!\uparrow)$ of the modified refractive index region is expressed by $S(r\!\uparrow) = S_0 + \Delta S(r\!\uparrow)$ using the reference area $S_0$ as in the first embodiment.

Next, an example of a two-dimensional photonic crystal laser of a third embodiment manufactured so as to form characters as a far-field image will be described together with a comparative example. In each of the example and comparative example, $E_{far\_iFFT}(K\!\uparrow)$ was determined so as to form a far-field image in which a character string of "Kyoto" and a character string of "Univ." in horizontal writing were vertically arranged. The modified refractive index region was disposed with a positional shift amount and an area shift amount (both of these; these shift amounts differ between the example and comparative example) to be described later so that the position in a case where there is no positional shift in the example and comparative example has a square lattice shape with a period length a (= 195 nm). In the example, B in Expression (24) was set to 2.5, $\Delta d$ was set to 0.08a, C in Expression (25) was set to 2.5, $\Delta S$ was set to $0.03a^2$, and $S_0$ was set to $0.10a^2$. In the comparative example, without setting the upper limit value and the lower limit value, the positional shift amount $\Delta d(r\!\uparrow)$ was set to $B\cdot\Delta d\cdot\sin(\Psi(r\!\uparrow))$ and the area shift amount $\Delta S(r\!\uparrow)$ was set to $C\cdot\Delta S\cdot\sin(\Psi(r\!\uparrow))$ in all the modified refractive index regions, and the same values as those in the example were used for B, $\Delta d$, C, $\Delta S$, and $S_0$.

Fig. 13 is a photograph of a far-field image obtained in the example. A far-field image including a character string as designed is obtained. This indicates that even in the two-dimensional photonic crystal laser of the third embodiment, it is possible to form a pattern of clear characters or the like while suppressing adverse effects such as disappearance of laser light due to high-order diffraction.

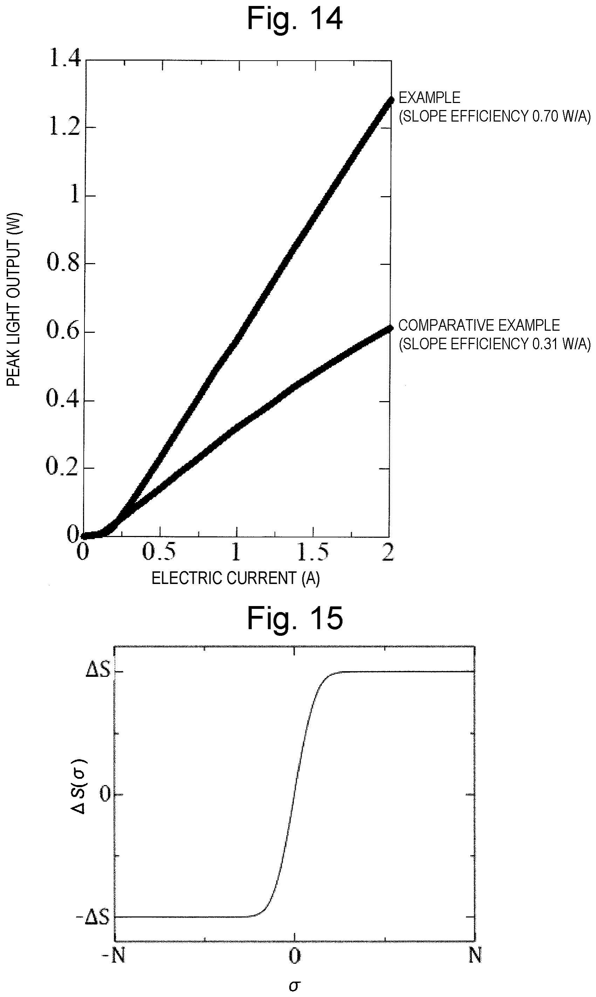

Fig. 14 illustrates a result obtained by experimentally determining a relationship between a peak light output, which is a light output of a laser beam during supply of a pulse electric current into a two-dimensional photonic crystal laser, and a magnitude of an electric current for each of the example and comparative example. Here, a pulse width of the pulse electric current was set to 100 nanoseconds. When comparison is made with the same electric current value, the peak light output is larger in the example than in the comparative example. Values of slope efficiency obtained from the experimental results are 0.70 W/A in the example and 0.31 W/A in the comparative example. As described above, the two-dimensional photonic crystal laser according to the third embodiment can realize high slope efficiency while suppressing high-order diffraction as described above.

(4) Fourth Embodiment

In a fourth embodiment, the positional shift amount and/or the area shift amount of each of the plurality of modified refractive index regions are/is defined by a function that is saturated at the upper limit value and the lower limit value with the position of the lattice point as a variable. An example of such a function is a sigmoid function. There are several forms of sigmoid functions, but for example, an error function generally takes the variable as x and is expressed as follows:
[Expression 18]

$$erf(x) = \frac{2}{\sqrt{\pi}} \int_0^x \exp\left(-t'^2\right) dt' \quad \cdots(26)$$

Here, the variable x is replaced with a variable $\sigma$ including the position vector $r\!\uparrow$ expressed by Expression (11), a maximum value of the positional shift amount is $\Delta d$, a maximum value of the area shift amount is $\Delta S$, and the positional shift amount and the area shift amount are defined as functions $\Delta d(\sigma)$ and $\Delta S(\sigma)$ of the variable $\sigma$ as in the following Expression (27).
[Expression 19]

$$erf(\sigma) = \frac{2}{\sqrt{\pi}} \int_0^{\sigma} \exp\left(-t'^2\right) dt' \qquad \cdots(27)$$

Here, t is an arbitrary constant. Since the variable $\sigma$ includes the position vector r↑, $\Delta d(\sigma)$ and $\Delta S(\sigma)$ are also functions with the position as a variable.

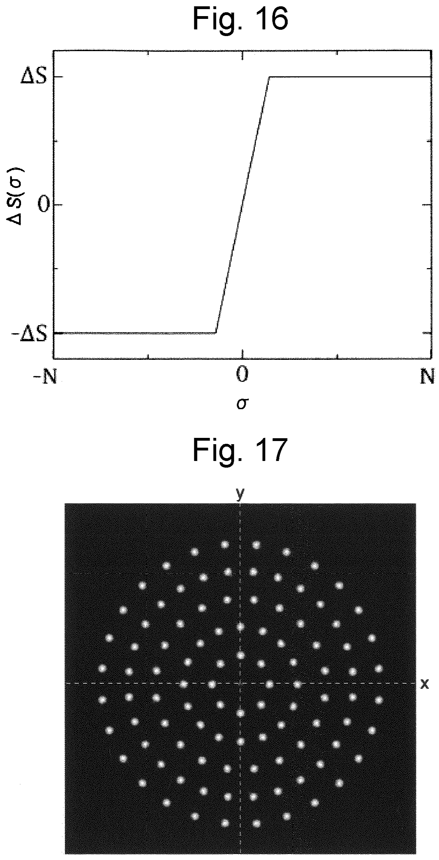

The function $\Delta S(\sigma)$ (hereinafter, the same applies to $\Delta d(\sigma)$ in this paragraph) of Expression (27) is saturated at the lower limit value -$\Delta S$ as $\sigma$ approaches negative infinity, and is saturated at the upper limit value $\Delta S$ as $\sigma$ approaches positive infinity. A slope monotonically increases with an increase in $\sigma$ near $\sigma = 0$, and the slope is approximately (0.8/t) at $\sigma = 0$. For example, if t = 0.09 in Expression (27), $\Delta S(\sigma)$ is saturated at the lower limit value -$\Delta S$ and the upper limit value $\Delta S$ as illustrated in the graph of Fig. 15, and the slope is approximately 8.9 at $\sigma = 0$. As described above, the change by $\sigma$ shown when the function $\Delta S(a)$ of Expression (27) is t = 0.09 is a change close to the graph of Fig. 16 in which the area shift amount determined using 50 types (N = 50) of vectors $k_n$↑ in the calculation example (Fig. 6) shown in the first embodiment is expressed by $\sigma$.

In the case of t = 0.09 in Expression (27) as described above, the intensity of the spot of the laser beam was obtained by calculation under conditions of $\Delta d = 0.008a$, $S_0 = 0.095a^2$, and $\Delta S = 0.03a^2$ as in the calculation example of Fig. 6. As a result, as illustrated in Fig. 17, a spot of an unnecessary laser beam illustrated in the comparative example in Fig. 7 was hardly generated, and a spot close to the calculation example of Fig. 6 was obtained.

Although the example of determining the positional shift amount and the area shift amount of the modified refractive index region using the error function, which is one of the sigmoid functions, has been described above, a sigmoid function other than the error function or another function may be used as long as the function is saturated at the upper limit value and the lower limit value with the position of the lattice point as a variable.

The method of determining the positional shift amount and the area shift amount of the modified refractive index region using the sigmoid function can be similarly applied to the case of forming the distribution of the laser spots showing various patterns described in the third embodiment. Specifically, using the modulation phase $\Psi(r↑)$ expressed by Expression (22) obtained from Expression (21), a function $\Delta d(\sigma_d)$ having $\Delta d(r↑) = B\cdot\Delta d\cdot\sin(\Psi(r↑))$, which is a function of r↑ expressed by Expression (23), as a variable $\sigma_d$ with respect to the positional shift amount, and a function $\Delta S(\sigma_s)$ having $\Delta S(r↑) = C\cdot\Delta S\cdot\sin(\Psi(r↑))$ as a variable $\sigma_s$ with respect to the area shift amount are set as the positional shift amount and the area shift amount. The functions $\Delta d(\sigma_d)$ and $\Delta S(\sigma_s)$ are expressed as follows:
[Expression 20]

$$\Delta d(\sigma_d) = \Delta d \cdot \frac{erf(\sigma_d)}{\sqrt{2}\cdot t}$$
$$\Delta S(\sigma_S) = \Delta S \cdot \frac{erf(\sigma_S)}{\sqrt{2}\cdot t}$$

$$erf(\sigma_d) = \frac{2}{\sqrt{\pi}} \int_0^{\sigma_d} \exp\left(-t'^2\right) dt'$$
$$erf(\sigma_S) = \frac{2}{\sqrt{\pi}} \int_0^{\sigma_S} \exp\left(-t'^2\right) dt'$$
$$\cdots(28)$$

[Modes]

A person skilled in the art can understand that the previously described illustrative embodiment is a specific example of the following modes of the present invention.

(Clause 1) A two-dimensional photonic crystal laser according to a mode of the present invention includes:

a) a pair of electrodes;
b) an active layer that is provided between the pair of electrodes and generates light having a predetermined wavelength when an electric current is supplied from the electrodes; and
c) a two-dimensional photonic crystal layer provided between any one of the pair of electrodes and the active layer and having a plate-like base member and a plurality of modified refractive index regions disposed in the base member and having a refractive index different from that of the base member, wherein

each of the plurality of modified refractive index regions is disposed to be shifted from each lattice point of a two-dimensional lattice periodically disposed in the base member in an in-plane period corresponding to the predetermined wavelength by a different positional shift amount, and/or has an amount of area different from a predetermined reference area by an area shift amount different from each other at each lattice point of the two-dimensional lattice or at a position shifted from the lattice points by the positional shift amount, and

the positional shift amount and/or the area shift amount of each of the plurality of modified refractive index regions are/is a modulation value determined by a composite period obtained by superimposing a plurality of different in-plane periods at a modified refractive index region in which the modulation value is a value between a predetermined upper limit value and a predetermined lower limit value at a lattice point at which the modified refractive index region is disposed, are/is the upper limit value at a modified refractive index region in which the modulation value exceeds the upper limit value, and are/is the lower limit value at a modified refractive index region in which the modulation value is less than the lower limit value.

(Clause 2) A two-dimensional photonic crystal laser according to Clause 2 is the two-dimensional photonic crystal laser according to Clause 1, wherein

using a vector $r\uparrow$ indicating a position of each lattice point of the two-dimensional lattice, a vector $k_n\uparrow$ indicating a combination of an inclination angle and an azimuth angle of each of n (n is an integer of 2 or more) laser beams having different inclination angles and/or azimuth angles, an amplitude $A_n$ and a phase $\exp(i\alpha_n)$ determined for each n, and a constant $\Delta d$, a modulation value $\Delta d'(r\uparrow)$ of the positional shift amount at each lattice point is expressed as follows:

[Expression 21]

$$\Delta d' \left( r \uparrow \right) = \frac{\Delta d}{\sqrt{\sum_n A_n^2}} \sum_n A_n \sin \left( k_n \uparrow \cdot r \uparrow + \alpha_n \right)$$

(Clause 3) A two-dimensional photonic crystal laser according to Clause 3 is the two-dimensional photonic crystal laser according to Clause 1, wherein

using a vector $r\uparrow$ indicating a position of each lattice point of the two-dimensional lattice, a vector $k_n\uparrow$ indicating a combination of an inclination angle and an azimuth angle of each of n (n is an integer of 2 or more) laser beams having different inclination angles and/or azimuth angles, an amplitude $A_n$ and a phase $\exp(i\alpha_n)$ determined for each n, and a constant $\Delta S$, a modulation value $\Delta S'(r\uparrow)$ of the area shift amount at each lattice point is expressed as follows:

[Expression 22]

$$\Delta S' \left( r \uparrow \right) = \frac{\Delta S}{\sqrt{\sum_n A_n^2}} \sum_n A_n \sin \left( k_n \uparrow \cdot r \uparrow + \alpha_n \right)$$

(Clause 4) A two-dimensional photonic crystal laser according to Clause 4 is the two-dimensional photonic crystal laser according to Clause 1 or Clause 3, wherein

the two-dimensional lattice is a first square lattice that is a square lattice, and
each of the plurality of modified refractive index regions is disposed without being shifted from a first lattice point that is a lattice point of the first square lattice, and each of the plurality of modified refractive index regions has an amount of area determined by the area shift amount, and
the two-dimensional photonic crystal laser further includes a plurality of second modified refractive index regions having a refractive index different from a refractive index of the base member, wherein
each of the plurality of second modified refractive index regions is disposed without being shifted from a second lattice point that is a lattice point of a second square lattice that is a square lattice having a same period length as the first square lattice and disposed at a position different from the first square lattice, and
an amount of area of each of the second modified refractive index regions at each second lattice point is the modulation value at a modified refractive index region in which the modulation value is a value between a predetermined second upper limit value and a predetermined second lower limit value at the second lattice point, is the second upper limit value at a modified refractive index region in which the modulation value exceeds the second upper limit value, and is a value shifted from a predetermined second reference area by a second area shift amount that is the second lower limit value at a modified refractive index region in which the modulation value is less than the second lower limit value.

(Clause 5) A two-dimensional photonic crystal laser according to Clause 5 is the two-dimensional photonic crystal laser according to any one of Clauses 1 to 3, wherein

the two-dimensional lattice is a first square lattice that is a square lattice, and
each of the plurality of modified refractive index regions is disposed to be shifted from the first lattice point that is a lattice point of the first square lattice by the positional shift amount, and each of the plurality of modified refractive index regions has an amount of area determined by the area shift amount, and
the two-dimensional photonic crystal laser further includes a plurality of second modified refractive index regions having a refractive index different from the refractive index of the base member, wherein
each of the plurality of second modified refractive index regions is disposed without being shifted from a second lattice point that is a lattice point of a second square lattice that is a square lattice having a same period length as the first square lattice and are disposed at a position different from the first square lattice, and each of the plurality of second modified refractive index region has a same amount of area.

(Clause 6) A two-dimensional photonic crystal laser according to Clause 6 is the two-dimensional photonic crystal laser according to Clause 4 or Clause 5, wherein the second square lattice is disposed to be shifted by 0.4 to 0.6 periods (more preferably 0.5 period) in a same direction as one of two basic translation vectors of the first square lattice.
(Clause 7) A two-dimensional photonic crystal laser according to Clause 7 is the two-dimensional photonic crystal laser according to Clause 1, wherein
with a modulation phase $\Psi(r\uparrow)$ expressed as follows:

[Expression 24]

$$\Psi\left(r\uparrow\right) = \arcsin\left[\pm\frac{\mathrm{Real}\left[E_{\mathrm{rad\_iFFT}}\left(r\uparrow\right)\right]}{\mathrm{Max}\left\{\mathrm{Real}\left[E_{\mathrm{rad\_iFFT}}\left(r\uparrow\right)\right]\right\}}\right]$$

using a target radiated electric field distribution $E_{\mathrm{rad\_iFFT}}$ that is an electric field distribution in a real space in a cross section parallel to the layer of the two-dimensional photonic crystal layer, the electric field distribution being an inverse Fourier transform of an electric field distribution $E_{\mathrm{far\_iFFT}}(K\uparrow)$ in a wave number space corresponding to a far-field image to be formed by a laser beam emitted from the two-dimensional photonic crystal laser, and is expressed as follows using a position vector $r\uparrow$ and a wave number vector $K\uparrow$ of each lattice point:

[Expression 23]

$$E_{\mathrm{rad\_iFFT}}\left(r\uparrow\right) = C\int\int A\left(K\uparrow\right)E_{\mathrm{far\_iFFT}}\left(K\uparrow\right)\exp\left(iK\uparrow\cdot r\uparrow\right)dK\uparrow$$

$\Delta d(r\uparrow)$ that is a positional shift amount of each of the plurality of modified refractive index regions and/or $\Delta S(r\uparrow)$ that is an area shift amount of each of the plurality of modified refractive index regions are/is expressed as follows using $\Delta d$ that is the upper limit value of the positional shift amount and/or $\Delta S$ that is the upper limit value of the area shift amount:

$$\Delta d(r\uparrow) = B\cdot\Delta d\cdot\sin(\Psi(r\uparrow)) \text{ (when }|B\cdot\sin(\Psi(r\uparrow))|\leq 1; B \text{ is a constant)}$$

$$\Delta d \text{ (when } B\cdot\sin(\Psi(r\uparrow)) > 1)$$

$$-\Delta d \text{ (when } B\cdot\sin(\Psi(r\uparrow)) < -1)$$

and/or

$$\Delta S(r\uparrow) = C \cdot \Delta S \cdot \sin(\Psi(r\uparrow)) \ (when |C \cdot \sin(\Psi(r\uparrow))| \le 1)$$

$$\Delta S \ (when \ C \cdot \sin(\Psi(r\uparrow)) > 1)$$

$$-\Delta S \ (when \ C \cdot \sin(\Psi(r\uparrow)) < -1).$$

(Clause 8) A two-dimensional photonic crystal laser according to Clause 8 is the two-dimensional photonic crystal laser according to Clause 1, wherein the positional shift amount and/or the area shift amount of each of the plurality of modified refractive index regions are/is expressed by a function saturated at the upper limit value and the lower limit value, respectively, with the position of the lattice point as a variable.

(Clause 9) A two-dimensional photonic crystal laser according to Clause 9 is the two-dimensional photonic crystal laser according to Clause 8, wherein $\Delta d(\sigma)$ that is a positional shift amount of each of the plurality of modified refractive index regions and/or $\Delta S(\sigma)$ that is an area shift amount of each of the plurality of modified refractive index regions are/is a function with $\sigma$ as a variable, $\sigma$ being expressed as follows:

[Expression 25]

$$\sigma = \sum_{n} \sin\left(k_{n}\uparrow \cdot r\uparrow + \alpha_{n}\right)$$

using a position vector $r\uparrow$ of each lattice point, a vector $k_{n}\uparrow$ indicating a combination of an inclination angle and an azimuth angle of each of n (n is an integer of 2 or more) laser beams having different inclination angles and/or azimuth angles, and a phase $\exp(i\alpha_{n})$ determined for each n, and are/is expressed as follows using $\Delta d$ that is the upper limit value of the positional shift amount and/or $\Delta S$ that is the upper limit value of the area shift amount, and a constant t:

[Expression 26]

$$erf(\sigma) = \frac{2}{\sqrt{\pi}} \int_{0}^{\sigma} \exp\left(-t'^{2}\right) dt'$$

(Clause 10) A two-dimensional photonic crystal laser according to Clause 10 is the two-dimensional photonic crystal laser according to Clause 8, wherein

being a function with a modulation phase $\Psi(r\uparrow)$ expressed as follows:

[Expression 28]

$$\Psi(r\uparrow) = \arcsin\left[\pm \frac{\text{Real}\left[E_{\text{rad\_iFFT}}(r\uparrow)\right]}{\text{Max}\left\{\text{Real}\left[E_{\text{rad\_iFFT}}(r\uparrow)\right]\right\}}\right]$$

using a target radiated electric field distribution $E_{\text{rad\_iFFT}}$ that is an electric field distribution in a real space in a cross section parallel to the layer of the two-dimensional photonic crystal layer, the electric field distribution being an inverse Fourier transform of an electric field distribution $E_{\text{far\_iFFT}}(K\uparrow)$ in a wave number space corresponding to a far-field image to be formed by a laser beam emitted from the two-dimensional photonic crystal laser, and is expressed as follows using a position vector $r\uparrow$ and a wave number vector $K\uparrow$ of each lattice point:

[Expression 27]

$$E_{\text{rad\_iFFT}}(r\uparrow) = C \int \int A(K\uparrow) E_{\text{far\_iFFT}}(K\uparrow) \exp(iK\uparrow \cdot r\uparrow) dK\uparrow$$

and with a variable $\sigma_{d}$ or $\sigma_{s}$ expressed by a constant B or C:

$$\sigma_d = B \cdot \Delta d \cdot \sin(\Psi(r\uparrow))$$

$$\sigma_S = C \cdot \Delta S \cdot \sin(\Psi(r\uparrow)),$$

$\Delta d(\sigma_d)$ that is a positional shift amount of each of the plurality of modified refractive index regions and/or $\Delta S(\sigma_s)$ that is an area shift amount of each of the plurality of modified refractive index regions are/is expressed as follows using $\Delta d$ that is the upper limit value of the positional shift amount and/or $\Delta S$ that is the upper limit value of the area shift amount:

[Expression 29]

$$\Delta d\left(\sigma_{\mathrm{d}}\right) = \Delta d \cdot \frac{erf\left(\sigma_{\mathrm{d}}\right)}{\sqrt{2} \cdot t}$$
$$\Delta S\left(\sigma_{\mathrm{S}}\right) = \Delta S \cdot \frac{erf\left(\sigma_{\mathrm{S}}\right)}{\sqrt{2} \cdot t}$$

$$erf\left(\sigma_{\mathrm{d}}\right) = \frac{2}{\sqrt{\pi}} \int_{0}^{\sigma_{\mathrm{d}}} \exp\left(-t'^{2}\right) dt'$$
$$erf\left(\sigma_{\mathrm{S}}\right) = \frac{2}{\sqrt{\pi}} \int_{0}^{\sigma_{\mathrm{S}}} \exp\left(-t'^{2}\right) dt'$$

REFERENCE SIGNS LIST

10, 20... Two-Dimensional Photonic Crystal Laser
11... Active Layer
12, 22... Two-Dimensional Photonic Crystal Layer
121, 221... Base Member
122... Modified Refractive Index Region
1221... Modified Refractive Index Region at Lattice Point
1222... Modified Refractive Index Region Disposed to Be Shifted from Lattice Point in Positive Direction with Respect to y Direction
1223... Modified Refractive Index Region Disposed to Be Shifted from Lattice Point in Negative Direction with Respect to y Direction
13... Spacer Layer
141... First Cladding Layer
142... Second Cladding Layer
16... Substrate
171... First Electrode
172... Second Electrode
1721... Frame Portion
1722... Window Portion
2221, 2221A... First Modified Refractive Index Region
2222, 2222A... Second Modified Refractive Index Region
2231... First Square Lattice
2232... Second Square Lattice
2241... First Lattice Point
2242... Second Lattice Point

Claims

1. A two-dimensional photonic crystal laser comprising:

a) a pair of electrodes;

b) an active layer that is provided between the pair of electrodes and generates light having a predetermined wavelength when an electric current is supplied from the electrodes; and

c) a two-dimensional photonic crystal layer provided between any one of the pair of electrodes and the active layer and having a plate-like base member and a plurality of modified refractive index regions disposed in the base member and having a refractive index different from that of the base member, wherein

each of the plurality of modified refractive index regions is disposed to be shifted from each lattice point of a two-dimensional lattice periodically disposed in the base member in an in-plane period corresponding to the predetermined wavelength by a different positional shift amount, and/or has an amount of area different from a predetermined reference area by an area shift amount different from each other at each lattice point of the two-dimensional lattice or at a position shifted from the lattice points by the positional shift amount, and

the positional shift amount and/or the area shift amount of each of the plurality of modified refractive index regions are/is a modulation value determined by a composite period obtained by superimposing a plurality of different in-plane periods at a modified refractive index region in which the modulation value is a value between a predetermined upper limit value and a predetermined lower limit value at a lattice point at which the modified refractive index region is disposed, are/is the upper limit value at a modified refractive index region in which the modulation value exceeds the upper limit value, and are/is the lower limit value at a modified refractive index region in which the modulation value is less than the lower limit value.

2. The two-dimensional photonic crystal laser according to claim 1, wherein

using a vector $r\uparrow$ indicating a position of each lattice point of the two-dimensional lattice, a vector $k_n\uparrow$ indicating a combination of an inclination angle and an azimuth angle of each of n (n is an integer of 2 or more) laser beams having different inclination angles and/or azimuth angles, an amplitude $A_n$ and a phase $\exp(i\alpha_n)$ determined for each n, and a constant $\Delta d$, a modulation value $\Delta d'(r\uparrow)$ of the positional shift amount at each lattice point is expressed as follows:

[Expression 1]

$$\Delta d'\left(r\uparrow\right) = \frac{\Delta d}{\sqrt{\sum_n A_n^2}} \sum_n A_n \sin\left(k_n\uparrow \cdot r\uparrow + \alpha_n\right)$$

3. The two-dimensional photonic crystal laser according to claim 1, wherein

using a vector $r\uparrow$ indicating a position of each lattice point of the two-dimensional lattice, a vector $k_n\uparrow$ indicating a combination of an inclination angle and an azimuth angle of each of n (n is an integer of 2 or more) laser beams having different inclination angles and/or azimuth angles, an amplitude $A_n$ and a phase $\exp(i\alpha_n)$ determined for each n, and a constant $\Delta S$, a modulation value $\Delta S'(r\uparrow)$ of the area shift amount at each lattice point is expressed as follows:

[Expression 2]

$$\Delta S'\left(r\uparrow\right) = \frac{\Delta S}{\sqrt{\sum_n A_n^2}} \sum_n A_n \sin\left(k_n\uparrow \cdot r\uparrow + \alpha_n\right)$$

4. The two-dimensional photonic crystal laser according to claim 1, wherein

the two-dimensional lattice is a first square lattice that is a square lattice, and

each of the plurality of modified refractive index regions is disposed without being shifted from a first lattice point that is a lattice point of the first square lattice, and each of the plurality of modified refractive index regions has an amount of area determined by the area shift amount, and

the two-dimensional photonic crystal laser further comprises a plurality of second modified refractive index regions having a refractive index different from a refractive index of the base member, wherein

each of the plurality of second modified refractive index regions is disposed without being shifted from a second lattice point that is a lattice point of a second square lattice that is a square lattice having a same period length as the first square lattice and disposed at a position different from the first square lattice, and

an amount of area of each of the second modified refractive index regions at each second lattice point is the modulation value at a modified refractive index region in which the modulation value is a value between a predetermined second upper limit value and a predetermined second lower limit value at the second lattice point, is the second upper limit value at a modified refractive index region in which the modulation value exceeds the second upper limit value, and is a value shifted from a predetermined second reference area by a second area shift amount that is the second lower limit value at a modified refractive index region in which the modulation value is less than the second lower limit value.

5. The two-dimensional photonic crystal laser according to claim 1, wherein

the two-dimensional lattice is a first square lattice that is a square lattice, and
each of the plurality of modified refractive index regions is disposed to be shifted from the first lattice point that is a lattice point of the first square lattice by the positional shift amount, and each of the plurality of modified refractive index regions has an amount of area determined by the area shift amount, and
the two-dimensional photonic crystal laser further comprises a plurality of second modified refractive index regions having a refractive index different from the refractive index of the base member, wherein
each of the plurality of second modified refractive index regions is disposed without being shifted from a second lattice point that is a lattice point of a second square lattice that is a square lattice having a same period length as the first square lattice and disposed at a position different from the first square lattice, and each of the plurality of second modified refractive index region has a same amount of area.

6. The two-dimensional photonic crystal laser according to claim 4 or 5, wherein the second square lattice is disposed to be shifted by a period within a range of 0.4 to 0.6 periods in a same direction as one of two basic translation vectors of the first square lattice.

7. The two-dimensional photonic crystal laser according to claim 1, wherein
with a modulation phase $\Psi(r\uparrow)$ expressed as follows:

[Expression 4]

$$\Psi(r\uparrow) = \arcsin\left[\pm\frac{\mathrm{Real}\left[E_{\mathrm{rad\_iFFT}}(r\uparrow)\right]}{\mathrm{Max}\left\{\mathrm{Real}\left[E_{\mathrm{rad\_iFFT}}(r\uparrow)\right]\right\}}\right]$$

using a target radiated electric field distribution $E_{\mathrm{rad\_iFFT}}$ that is an electric field distribution in a real space in a cross section parallel to the layer of the two-dimensional photonic crystal layer, the electric field distribution being an inverse Fourier transform of an electric field distribution $E_{\mathrm{far\_iFFT}}(K\uparrow)$ in a wave number space corresponding to a far-field image to be formed by a laser beam emitted from the two-dimensional photonic crystal laser, and is expressed as follows using a position vector $r\uparrow$ and a wave number vector $K\uparrow$ of each lattice point:

[Expression 3]

$$E_{\mathrm{rad\_iFFT}}(r\uparrow) = C\int\int A(K\uparrow)E_{\mathrm{far\_iFFT}}(K\uparrow)\exp(iK\uparrow\cdot r\uparrow)\,dK\uparrow$$

$\Delta d(r\uparrow)$ that is a positional shift amount of each of the plurality of modified refractive index regions and/or $\Delta S(r\uparrow)$ that is an area shift amount of each of the plurality of modified refractive index regions are/is expressed as follows using $\Delta d$ that is the upper limit value of the positional shift amount and/or $\Delta S$ that is the upper limit value of the area shift amount:

$$\Delta d(r\uparrow) = B\cdot\Delta d\cdot\sin(\Psi(r\uparrow))\ (\text{when}|B\cdot\sin(\Psi(r\uparrow))|\leq 1;\ B\ \text{is a constant})$$

$$\Delta d\ (\text{when}\ B\cdot\sin(\Psi(r\uparrow)) > 1)$$

$$-\Delta d\ (\text{when}\ B\cdot\sin(\Psi(r\uparrow)) < -1)$$

and/or

$$\Delta S(r\uparrow) = C\cdot\Delta S\cdot\sin(\Psi(r\uparrow))\ (\text{when}|C\cdot\sin(\Psi(r\uparrow))|\leq 1)$$

$$\Delta S \text{ (when } C \cdot \sin(\Psi(r\uparrow)) > 1)$$

$$-\Delta S \text{ (when } C \cdot \sin(\Psi(r\uparrow)) < -1).$$

8.  The two-dimensional photonic crystal laser according to claim 1, wherein the positional shift amount and/or the area shift amount of each of the plurality of modified refractive index regions are/is expressed by a function saturated at the upper limit value and the lower limit value, respectively, with a position of the lattice point as a variable.

9.  The two-dimensional photonic crystal laser according to claim 8, wherein

    $\Delta d(\sigma)$ that is a positional shift amount of each of the plurality of modified refractive index regions and/or $\Delta S(\sigma)$ that is an area shift amount of each of the plurality of modified refractive index regions are/is a function with $\sigma$ as a variable, $\sigma$ being expressed as follows:

    [Expression 5]

    $$\sigma = \sum_{n} \sin\left(k_n \uparrow \cdot r \uparrow + \alpha_n\right)$$

    using a position vector $r\uparrow$ of each lattice point, a vector $k_n\uparrow$ indicating a combination of an inclination angle and an azimuth angle of each of n (n is an integer of 2 or more) laser beams having different inclination angles and/or azimuth angles, and a phase $\exp(i\alpha_n)$ determined for each n, and are/is
    expressed as follows using $\Delta d$ that is the upper limit value of the positional shift amount and/or $\Delta S$ that is the upper limit value of the area shift amount, and a constant t:

    [Expression 6]

    $$erf\left(\sigma\right) = \frac{2}{\sqrt{\pi}} \int_0^{\sigma} \exp\left(-t'^2\right) dt'$$

10. The two-dimensional photonic crystal laser according to claim 8, wherein

    being a function with a modulation phase $\Psi(r\uparrow)$ expressed as follows:

    [Expression 8]

    $$\Psi\left(r \uparrow\right) = \arcsin\left[\pm\frac{\text{Real}\left[E_{\text{rad\_iFFT}}\left(r \uparrow\right)\right]}{\text{Max}\left\{\text{Real}\left[E_{\text{rad\_iFFT}}\left(r \uparrow\right)\right]\right\}}\right]$$

    using a target radiated electric field distribution $E_{\text{rad\_iFFT}}$ that is an electric field distribution in a real space in a cross section parallel to the layer of the two-dimensional photonic crystal layer, the electric field distribution being an inverse Fourier transform of an electric field distribution $E_{\text{far\_iFFT}}(K\uparrow)$ in a wave number space corresponding to a far-field image to be formed by a laser beam emitted from the two-dimensional photonic crystal laser, and is expressed as follows using a position vector $r\uparrow$ and a wave number vector $K\uparrow$ of each lattice point:

    [Expression 7]

    $$E_{\text{rad\_iFFT}}\left(r \uparrow\right) = C \int \int A\left(K \uparrow\right) E_{\text{far\_iFFT}}\left(K \uparrow\right) \exp\left(iK \uparrow \cdot r \uparrow\right) dK \uparrow$$

    and with a variable $\sigma_d$ or $\sigma_S$ expressed by a constant B or C:

$$\sigma_d = B \cdot \Delta d \cdot \sin(\Psi(r\uparrow))$$

$$\sigma_S = C \cdot \Delta S \cdot \sin(\Psi(r\uparrow)),$$

$\Delta d(\sigma_d)$ that is a positional shift amount of each of the plurality of modified refractive index regions and/or $\Delta S(\sigma_S)$ that is an area shift amount of each of the plurality of modified refractive index regions are/is expressed as follows using $\Delta d$ that is the upper limit value of the positional shift amount and/or $\Delta S$ that is the upper limit value of the area shift amount:

[Expression 9]

$$\Delta d\left(\sigma_d\right) = \Delta d \cdot \frac{erf\left(\sigma_d\right)}{\sqrt{2} \cdot t}$$
$$\Delta S\left(\sigma_S\right) = \Delta S \cdot \frac{erf\left(\sigma_S\right)}{\sqrt{2} \cdot t}$$

$$erf\left(\sigma_d\right) = \frac{2}{\sqrt{\pi}} \int_0^{\sigma_d} \exp\left(-t'^2\right) dt'$$
$$erf\left(\sigma_S\right) = \frac{2}{\sqrt{\pi}} \int_0^{\sigma_S} \exp\left(-t'^2\right) dt'$$

# Fig. 1

(a)

(b)

$\Delta d(r\uparrow)=0$
$\Delta S(r\uparrow)=0$
$(S=S_0)$

## Fig. 2

## Fig. 3

# Fig. 4

# Fig. 5

# Fig. 6

<FIRST EMBODIMENT>

# Fig. 7

<COMPARATIVE EXAMPLE>

# Fig. 8

# Fig. 9

(a)

(b)

# Fig. 10

# Fig. 11

(a) SECOND EMBODIMENT (DOUBLE LATTICE)

2222          2221

(b) EXAMPLE OF MODULATION OF AREA ONLY IN FIRST EMBODIMENT (SINGLE LATTICE)

122 (CORRESPONDING
TO 2221)

# Fig. 12

# Fig. 13

30°

# Fig. 14

# Fig. 15

# Fig. 16

# Fig. 17

## INTERNATIONAL SEARCH REPORT

International application No.

**PCT/JP2024/005062**

| A. | CLASSIFICATION OF SUBJECT MATTER |
|---|---|

*H01S 5/11*(2021.01)i; *H01S 5/18*(2021.01)i
FI:   H01S5/11; H01S5/18

According to International Patent Classification (IPC) or to both national classification and IPC

| B. | FIELDS SEARCHED |
|---|---|

Minimum documentation searched (classification system followed by classification symbols)

H01S5/00-5/50

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | WO 2022/181723 A1 (KYOTO UNIVERSITY) 01 September 2022 (2022-09-01) entire text, all drawings | 1-10 |
| A | JP 2019-106398 A (HAMAMATSU PHOTONICS KK) 27 June 2019 (2019-06-27) entire text, all drawings | 1-10 |
| A | WO 2006/095648 A1 (KYOTO UNIVERSITY) 14 September 2006 (2006-09-14) entire text, all drawings | 1-10 |
| A | JP 2015-60880 A (UNIV. WAKAYAMA) 30 March 2015 (2015-03-30) entire text, all drawings | 1-10 |
| A | US 2006/0039433 A1 (SIMPSON, John T.) 23 February 2006 (2006-02-23) entire text, all drawings | 1-10 |

☐ Further documents are listed in the continuation of Box C.   ☑ See patent family annex.

| | |
|---|---|
| *    Special categories of cited documents: | "T"  later document published after the international filing date or priority date and not in conflict with the application but cited to understand the principle or theory underlying the invention |
| "A"  document defining the general state of the art which is not considered to be of particular relevance | |
| "D"  document cited by the applicant in the international application | "X"  document of particular relevance; the claimed invention cannot be considered novel or cannot be considered to involve an inventive step when the document is taken alone |
| "E"  earlier application or patent but published on or after the international filing date | |
| "L"  document which may throw doubts on priority claim(s) or which is cited to establish the publication date of another citation or other special reason (as specified) | "Y"  document of particular relevance; the claimed invention cannot be considered to involve an inventive step when the document is combined with one or more other such documents, such combination being obvious to a person skilled in the art |
| "O"  document referring to an oral disclosure, use, exhibition or other means | "&"  document member of the same patent family |
| "P"  document published prior to the international filing date but later than the priority date claimed | |

| Date of the actual completion of the international search | Date of mailing of the international search report |
|---|---|
| **21 March 2024** | **02 April 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**
Information on patent family members

International application No.

**PCT/JP2024/005062**

| Patent document cited in search report | | | Publication date (day/month/year) | Patent family member(s) | | | Publication date (day/month/year) |
|---|---|---|---|---|---|---|---|
| WO | 2022/181723 | A1 | 01 September 2022 | EP 4300731 A1 entire text, all drawings CN 116897478 A | | | |
| JP | 2019-106398 | A | 27 June 2019 | (Family: none) | | | |
| WO | 2006/095648 | A1 | 14 September 2006 | US 2008/0131660 A1 entire text, all drawings | | | |
| JP | 2015-60880 | A | 30 March 2015 | (Family: none) | | | |
| US | 2006/0039433 | A1 | 23 February 2006 | (Family: none) | | | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2014136607 A
- US 20160248224 A
- WO 2022181723 A